(19) Europäisches Patentamt
European Patent Office
Office européen des brevets

(11) EP 4 697 372 A1

(12) **EUROPEAN PATENT APPLICATION**
published in accordance with Art. 153(4) EPC

(43) Date of publication:
18.02.2026 Bulletin 2026/08

(51) International Patent Classification (IPC):
H01J 1/304 (2006.01)    H01J 1/46 (2006.01)
H01J 9/02 (2006.01)

(21) Application number: 24849315.7

(22) Date of filing: 30.01.2024

(52) Cooperative Patent Classification (CPC):
H01J 1/304; H01J 1/46; H01J 9/02

(86) International application number:
PCT/KR2024/001427

(87) International publication number:
WO 2025/028742 (06.02.2025 Gazette 2025/06)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 28.07.2023 KR 20230098651
22.12.2023 KR 20230189807

(71) Applicant: POSTECH Research and Business
Development
Foundation
Pohang-si, Gyeongsangbuk-do 37673 (KR)

(72) Inventors:
• KONG, Byoung-don
  Pohang-si Gyeongsangbuk-do 37673 (KR)

• YOON, Cheulhyun
  Pohang-si Gyeongsangbuk-do 37673 (KR)
• SEO, Gyeong Min
  Pohang-si Gyeongsangbuk-do 37673 (KR)
• YOON, Seokhyun
  Pohang-si Gyeongsangbuk-do 37673 (KR)
• LIM, Hyokyung
  Pohang-si Gyeongsangbuk-do 37673 (KR)
• JEON, Gilsu
  Pohang-si Gyeongsangbuk-do 37673 (KR)

(74) Representative: Jung, Minkyu
Wuesthoff & Wuesthoff
Patentanwälte und Rechtsanwalt PartG mbB
Schweigerstraße 2
81541 München (DE)

(54) **TRANSISTOR DEVICE COMPRISING EMITTER BASED ON METALLOID MATERIAL OF TWO-DIMENSIONAL STRUCTURE, DRIVING METHOD THEREOF, AND MANUFACTURING METHOD THEREOF**

(57)    A transistor device may include: an emitter located on a substrate including a dielectric material, the emitter being formed of a metalloid material with a two-dimensional (2D) structure and configured to selectively emit electrons; a source electrode electrically contacting a portion of the emitter; a drain electrode located on the substrate, spaced apart from the emitter, and electrically separated from the source electrode; and a gate structure located on the emitter and configured to apply a gate voltage for controlling electron emission by the emitter to the emitter by modulating a work function of the emitter. The transistor device may include a vacuum region as a path through which emitted electrons move, and may be a three-terminal or four-terminal field-effect transistor configured to adjust emission current by applying a gate voltage to change a Fermi level of the emitter tip of the 2D metalloid material.

[Fig. 2]

# EP 4 697 372 A1

**Description**

[Technical Field]

Embodiments relate to a transistor device, and particularly, to a transistor device using a vacuum channel. More particularly, embodiments relate to a transistor device including an emitter based on a metalloid material with a two-dimensional structure and high conductivity and using a vacuum as a channel, wherein modulation of the amount of current passing through and traversing the vacuum channel is enabled by applying a gate voltage to change a Fermi level and a work function of the emitter.

[Background Art]

A channel in a field-effect transistor (FET) device is typically formed of a solid semiconductor material. For example, Korean Patent No. 10-0973124 discloses a conventional FET having a channel including an oxide semiconductor material including indium and zinc.

The high-frequency performance of an FET having a solid-state channel is limited by a velocity limit of charge carriers (i.e., electrons and holes) of a semiconductor material forming the channel, which further determines device design limitations such as a distance between a source region and a drain region or a length of a gate electrode. For example, when the distance between the source region and the drain region (i.e., channel length) is reduced so that the FET operates at a higher frequency, a maximum allowable source-drain voltage decreases, and capacitance of a gate insulating film increases, consequentially limiting the output, gain and efficiency of the device.

Accordingly, in a conventional high-frequency power device based on a solid-state channel, a drift velocity of charge carriers may not exceed a saturation velocity due to a scattering effect in the solid channel. When a channel length is reduced to compensate for this limitation, other parameters such as output impedance and capacitance may be degraded, thereby reducing output power.

On the other hand, in a vacuum, a velocity of electrons, which are charge carriers, may greatly increase. In a vacuum, because all scattering components excluding electron-electron scattering are reduced, electrons passing through a vacuum channel may move at a much higher velocity than when passing through a solid-state channel. For example, a velocity of electrons accelerated to a kinetic energy of hundreds of eV is about $10^9$ cm/s in a vacuum, whereas the velocity is limited to a saturation velocity of about $10^7$ cm/s in a solid channel.

In order to use a vacuum as a path for charge carriers, electrons should be emitted into a space from an emitter, and methods of emitting electrons include an electron emission method through thermal energy, an emission method through optical energy, and a method of emitting electrons through a quantum mechanical tunneling effect of microparticles by applying an electric field. Among these methods, an electron emission device using an electric field effect based on tunneling may be sufficiently manufactured through a top-down planar lithography method.

In order to induce field emission, a large electric field should exist around a tip of an emitter where electron emission occurs, and when the tip of the emitter has a sharp and pointed geometric structure, a charge distribution inside the tip of the emitter is rearranged to compensate for an external electric field, thereby resulting in a locally increased charge density and a local field enhancement effect. Also, the local field enhancement effect induced by the geometric shape of the tip of the emitter may also be achieved at an edge of a two-dimensional (2D) material with high conductivity.

However, there was no transistor device configured to emit electrons in a quantum mechanical tunneling method using a field enhancement effect occurring at an edge of a 2D material with high conductivity. Also, a gate electrode for adjusting electron emission in an existing vacuum device should be located between a drain electrode and an emitter, and in this case, an interval between the drain electrode and the emitter increases, causing disadvantages in terms of an applied voltage required for device operation and electron mobility and limiting an operating speed of the device.

**[Disclosure]**

[Technical Problem]

According to an aspect of the present disclosure to solve problems of the prior art, there may be provided a transistor device including an emitter formed of a metalloid material with a two-dimensional structure and high conductivity and capable of changing a Fermi level and a work function of the emitter by applying a voltage to the emitter due to a gate structure and performing a switching operation and a rectification function by modulating the amount of current, and a method for operating the transistor device and a method for manufacturing the transistor device.

[Technical Solution]

A transistor device according to an aspect of the present disclosure includes: an emitter located on a substrate including a dielectric material, the emitter being formed of a metalloid material with a two-dimensional (2D) structure and configured to selectively emit electrons; a source electrode electrically contacting a portion of the emitter; a drain electrode located on the substrate, spaced apart from the emitter, and electrically separated from the source electrode; and a gate structure located on the emitter and configured to apply a gate voltage for controlling electron emission by the emitter to the emitter by modulating a work function of the emitter.

In the transistor device according to an embodiment, when a gate voltage and a drain voltage are applied to the emitter so that the emitter emits electrons, a vacuum channel through which electrons are movable is formed between a tip of the emitter toward the drain electrode and the drain electrode.

In an embodiment, a distance between the gate structure and the drain electrode is greater than or equal to a distance between the tip of the emitter and the drain electrode.

In an embodiment, the tip of the emitter protrudes toward the drain electrode relative to the gate structure, and a shortest distance between the tip of the emitter and the gate structure is 40 nm or less.

In an embodiment, the 2D structure of the metalloid material is parallel to a surface of the substrate, wherein the emitter is configured to emit electrons from the tip of the emitter in a direction parallel to the surface of the substrate.

In an embodiment, the tip of the emitter has a radius of curvature less than or equal to a preset value so that a field enhancement effect is induced at the tip of the emitter by a voltage between the source electrode and the drain electrode.

In an embodiment, the emitter includes one or more layers formed of graphene or reduced graphene oxide.

In an embodiment, the gate structure includes: a gate insulating film located on the emitter; and a gate electrode located on the gate insulating film and configured to apply the gate voltage.

In an embodiment, the gate electrode is configured to apply a first voltage to the emitter, wherein a magnitude of the first voltage is determined based on quantum capacitance of the emitter determined by a voltage between the source electrode and the drain electrode.

In an embodiment, a second voltage is applied between the source electrode and the drain electrode. In this case, a magnitude of the first voltage is greater than or equal to -10 V and less than 0 V, or greater than 0 V and less than or equal to 10 V, and a magnitude of the second voltage is greater than 0 V and less than or equal to 200 V.

A field-effect transistor according to an aspect of the present disclosure includes: the transistor device according to any one of the above embodiments and configured to operate in a vacuum state; and a conductive lead electrically connected to the source electrode, the gate structure, and the drain electrode of the transistor device.

A method for operating a transistor device according to an aspect of the present disclosure includes: preparing a source electrode located on a substrate including a dielectric material, and an emitter located on the substrate, electrically connected to the source electrode, and formed of a metalloid material with a two-dimensional (2D) structure; modulating a work function of the emitter by applying a gate voltage to the emitter via a gate structure located on the emitter; and emitting electrons from a tip of the emitter, to which the gate voltage and a drain voltage are applied, toward a drain electrode electrically separated from the source electrode and spaced apart from the emitter.

In an embodiment, the emitting of the electrons includes emitting electrons from the emitter into a vacuum region between the tip of the emitter and the drain electrode.

In an embodiment, the modulating of the work function of the emitter includes: applying a first voltage to the tip of the emitter via a gate electrode; and determining a magnitude of the first voltage based on quantum capacitance of the emitter determined by a voltage between the source electrode and the drain electrode.

The method for operating the transistor device according to an embodiment further includes applying a second voltage between the source electrode and the drain electrode. In this case, the first voltage is greater than or equal to -10 V and less than 0 V, or greater than 0 V and less than or equal to 10 V, and the second voltage is greater than 0 V and less than or equal to 200 V.

A method for manufacturing a transistor device according to an aspect of the present disclosure includes: forming an emitter having a two-dimensional (2D) structure formed of a metalloid material on a substrate including a dielectric material; forming a gate insulating film on the metalloid material layer; forming a gate electrode on the gate insulating film; partially removing the dielectric material; and forming a source electrode electrically connected to a portion of the emitter and a drain electrode spaced apart from the emitter. In this case, the gate electrode is located between the source electrode and the drain electrode.

The partially removing of the dielectric material includes forming an undercut below the metalloid material layer.

In an embodiment, the forming of the gate insulating film includes forming an insulating layer having a thickness less than or equal to a distance between the gate electrode and the emitter so that a voltage applied by the gate electrode modulates a work function of the emitter.

In an embodiment, the forming of the emitter includes: forming a metalloid material layer with a 2D structure having an edge with a radius of curvature less than or equal to a preset value on another substrate; and transferring the metalloid material layer to the substrate.

A transistor device according to still another aspect of the present disclosure includes: a first transistor element; and a second transistor element facing the first transistor element.

In this case, each of the first transistor element and the second transistor element includes: an emitter located on a substrate including a dielectric material, the emitter being formed of a metalloid material with a two-dimensional (2D) structure and configured to selectively emit electrons; a source electrode electrically contacting a portion of the emitter; a drain electrode located on the substrate, spaced apart from the emitter, and electrically separated from the source electrode; and a gate structure located on the emitter, and configured to apply a gate voltage for controlling electron emission by the emitter to the emitter by modulating a work function of the emitter.

Also, the first transistor element and the second transistor element are arranged so that directions of electron emission from the emitter toward the drain electrode are opposite to each other.

In an embodiment, the drain electrode of the first transistor element and the drain electrode of the second transistor element are integrally formed with each other.

In an embodiment, the drain electrode of each of the first transistor element and the second transistor element is formed on the substrate at a height lower than a top surface of the emitter.

[Advantageous Effects]

A transistor device according to an aspect of the present disclosure uses a vacuum region as a channel, uses a metalloid material with a two-dimensional (2D) structure as an emitter, and is configured to induce quantum tunneling of electrons through a field enhancement effect at an edge of the emitter. Unlike conventional solid channel-based transistors, in this transistor device, because electrons emitted through quantum tunneling may rapidly move without being affected by lattice scattering or the like, the transistor device may efficiently operate under a high-frequency condition.

A transistor device according to an aspect of the present disclosure may be implemented as a three-terminal or four-terminal field-effect transistor. Also, in the transistor device according to an aspect of the present disclosure, because a gate electrode is located in a channel portion of an emitter rather than located between the emitter and a drain electrode as in the prior art, there is no physical limitations on reducing a length of a vacuum channel, thereby improving an operating frequency of the transistor.

For example, a conventional high-frequency device using a solid semiconductor material as a channel has a problem in that output power decreases to less than several $\mu$W under a high-frequency condition of 300 GHz or more, and the output power continues to decrease as an operating frequency increases. On the other hand, a transistor device according to an aspect of the present disclosure has a cutoff frequency of about 0.41 to 1.72 THz and a maximum oscillation frequency of about $6.4 \times 10^2$ to $1.9 \times 10^4$ THz under a source-drain voltage of 90 to 100 V, and may operate without degradation of device performance even in a terahertz (THz) band.

[Description of Drawings]

FIG. 1 is a perspective view illustrating a transistor device using a metalloid material with a two-dimensional (2D) structure as an emitter according to an embodiment.

FIG. 2 is a cross-sectional view illustrating the transistor device of FIG. 1.

FIG. 3 is a flowchart illustrating each step of a method for operating a transistor device according to an embodiment.

FIG. 4 is a conceptual diagram for describing an operation of a transistor device according to an embodiment.

FIG. 5 is a diagram schematically illustrating an equivalent circuit structure of a transistor device according to an embodiment.

FIG. 6 is a graph illustrating current-voltage characteristics of a transistor device according to an embodiment.

FIGS. 7A and 7B are graphs illustrating a change in a band structure of each region of an emitter according to a voltage condition applied to each of a source electrode, a drain electrode, and a gate electrode in a transistor device according to an embodiment.

FIGS. 8A and 8B are graphs illustrating a voltage distribution of a region of a device and an adjacent space according to a voltage condition applied to each of a source electrode, a drain electrode, and a gate electrode in a transistor device according to an embodiment.

FIG. 9 is a graph illustrating a change in transconductance according to a change in a gate voltage in each source-drain voltage condition in a transistor device according to an embodiment.

FIG. 10A is a graph illustrating a change in a cutoff frequency according to a change in a gate voltage in each source-drain voltage condition in a transistor device according to an embodiment.

FIG. 10B is a graph illustrating a change in a maximum oscillation frequency according to a change in a gate voltage in each source-drain voltage condition in a transistor device according to an embodiment.

FIG. 11 is a graph illustrating a change in a work function of an emitter tip according to a change in a shortest distance between a gate electrode and the emitter tip, a source-drain voltage condition, and modulation of a gate voltage in a transistor device according to an embodiment.

FIG. 12 is a graph illustrating current-voltage characteristics when a length of a vacuum channel changes in a transistor device according to an embodiment.

FIG. 13 is a cross-sectional view illustrating a transistor device using a metalloid material with a 2D structure as an emitter according to still another embodiment.

FIGS. 14A and 14B are graphs illustrating current-voltage characteristics according to a voltage condition applied to each of a source electrode, a drain electrode, and a gate electrode in the transistor device of FIG. 13.

FIGS. 15A to 15C are graphs illustrating a change in a band structure of each region of an emitter according to a voltage condition applied to each of a source electrode, a drain electrode, and a gate electrode in the transistor device of FIG. 13.

FIG. 16 is a graph illustrating a change in transconductance according to a change in a gate voltage in each source-drain voltage condition in the transistor device of FIG. 13.

FIG. 17 is a flowchart illustrating each step of a method for manufacturing a transistor device according to an embodiment.

FIG. 18A is a cross-sectional view illustrating a transistor device according to still another embodiment.

FIG. 18B is a plan view illustrating the transistor device of FIG. 18A.

FIG. 19 is an optical microscope image of the transistor device manufactured according to the embodiment of FIGS. 18A and 18B.

FIGS. 20A and 20B are graphs illustrating emission current characteristics of the transistor device according to the embodiment of FIGS. 18A and 18B.

[Mode for Invention]

Hereinafter, embodiments of the present disclosure will be described in detail with reference to the drawings.

In describing embodiments of the present specification, detailed descriptions of related well-known functions or configurations that may blur the points of the embodiments of the present disclosure are omitted. Also, in the drawings, parts irrelevant to the description of embodiments of the present specification are omitted, and like reference numerals designate like elements throughout the present specification.

It will be understood that when an element is referred to as being "connected to," "coupled to," "accessed to" another element, it may be directly connected, coupled, or accessed to the other element or the intervening elements may be present. Also, it will be further understood that when an element "comprises/includes" or "has" another element, it specifies the presence of another element but does not preclude the presence of another element unless otherwise described.

In an embodiment of the present specification, the terms, such as first, second, and the like, may be used to describe the elements in the description herein, and these terms are used to distinguish one element from another and do not limit the order or importance of the elements unless otherwise stated. Therefore, within the scope of embodiments of the present specification, a first element in an embodiment may be referred to as a second element in another embodiment, and similarly, a second element in an embodiment may be referred to as a first element in another embodiment.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless explicitly defined in this application.

It will be understood that when a layer is referred to as being "on" another layer or substrate, it may be directly formed on the other layer or substrate, or a third layer may be present therebetween. In addition, as used herein, directional expressions such as upward, upper (portion), an upper surface, etc. may also be understood as downward, lower (portion), a lower surface, etc. depending on the reference. In other words, expressions of spatial directions should be understood as relative directions, and should not be construed as limited to absolute directions.

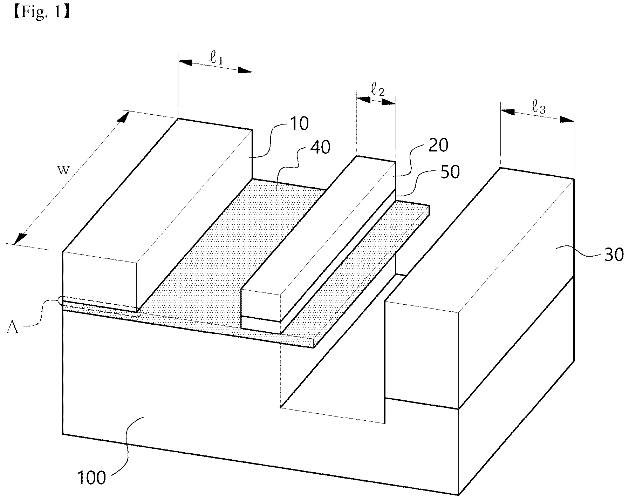

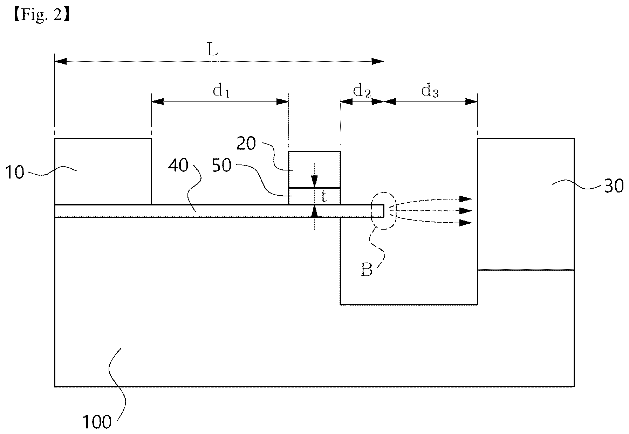

FIG. 1 is a perspective view illustrating a transistor device using a metalloid material with a two-dimensional (2D) structure as an emitter according to an embodiment, and FIG. 2 is a cross-sectional view illustrating the transistor device of FIG. 1.

Referring to FIGS. 1 and 2, a transistor device according to an embodiment includes a source electrode 10, an emitter 40 formed of a metalloid material with a 2D structure, a gate structure 20, 50 configured to apply a voltage to the emitter 40, and a drain electrode 30 electrically separated from the source electrode 10 and spaced apart from the emitter 40.

The transistor device according to embodiments may be located on a substrate 100 having a surface formed of a dielectric material. In the present specification, when the transistor device or some components thereof are located on the substrate 100, it may mean that the transistor device or some components thereof may directly contact the substrate 100 or may be indirectly disposed on the substrate 100 with one or more other material layers therebetween.

The substrate 100 having a surface formed of a dielectric material may be entirely formed of a dielectric material or may be formed so that a dielectric material layer, which is thick enough to avoid dielectric breakdown during operation of the transistor device, is disposed on a base member formed of another material. Also, it is preferable that the surface of the substrate 100 has high thermal conductivity in order to improve the performance of the transistor device.

The source electrode 10 and the drain electrode 30 are formed of a metal or any other conductive material. The source electrode 10 electrically contacts the emitter 40, and the drain electrode 30 is electrically separated from the source electrode 10 and the emitter 40. The gate structure 20, 50 is located on a portion of the emitter 40 between the source electrode 10 and the drain electrode 30. That is, the gate structure 20, 50 is located closer to the source electrode 10 than the drain electrode 50. Also, in the transistor device according to embodiments, the source electrode 10, a gate electrode 20, and the drain electrode 30 do not electrically contact each other.

In the present specification, when electrically contacting, it means that charge carriers are physical interfered with or adjusted to move from one portion to another portion through direct physical contact with another medium. For example, although the source electrode 10 is disposed on the substrate 100 and electrically contacts the emitter 40 in FIGS. 1 and 2, the gate electrode 20 and the drain electrode 30 do not electrically contact the emitter 40.

Although the drain electrode 40 is disposed on the substrate 400, it is spaced apart from the emitter 40 for a device operation design. There is a vacuum region for functioning as a vacuum channel between a tip B of the emitter 40 and the drain electrode 30 in a space between the gate electrode 20 and the drain electrode 30. The tip B of the emitter 40 does not contact other components (e.g., the gate electrode 20 and the drain electrode 30) of the transistor device, excluding the vacuum channel.

Other portions of the emitter 40, excluding the tip B, may contact a gate insulating film 50 of the gate structure, the source electrode 10, and the substrate 100. In FIG. 1, a region A represents a conductive contact region between the source electrode 10 and the emitter 40 in a cross-sectional view, and a conductive contact may be formed by two-dimensionally extending the region A along a surface of the emitter 40 with a 2D structure.

A positional relationship between the source electrode 10, the emitter 40, the gate structure 20, 50, and the drain electrode 30 in the transistor device according to embodiments is determined to secure a movement path of emitted electrons from the source electrode 10 through the gate structure 20, 50, the tip B of the emitter 40, and the vacuum channel toward the drain electrode 30.

The emitter 40 is electrically connected to the source electrode 10 in the conductive contact region A, and is formed of a metalloid material with a 2D structure. In this case, the term "2D structure" refers to a shape having an overall smooth flat plate form, where the tip B of the emitter 40 has a radius of curvature less than or equal to a preset value to induce a field enhancement effect. For example, the 2D structure may refer to a set of planar molecules with atomic-scale thickness, but this is only an example and does not mean that all atoms constituting the emitter 40 are perfectly located on the same geometric plane.

The conductive contact region A of the emitter 40 may be formed of a conductive material different from the metalloid material of other portions of the emitter 40, or may refer to a portion where the emitter 40 formed of the metalloid material contacts the source electrode 10. Also, because the tip B of the emitter 40 toward the drain electrode 30 is spaced apart from the drain electrode 30, the vacuum region is located between the emitter 40 and the drain electrode 30.

In the present specification, the metalloid material constituting the emitter 40 refers to a material with high electrical conductivity so that when a certain gate voltage is applied to the emitter 40, electrons are emitted from the tip B of the emitter 40 through quantum tunneling and the emitted electrons traverse the vacuum channel due to an electric field. The metalloid material constituting the emitter 40 in the transistor according to embodiments may include graphene, but the present disclosure is not limited thereto. Also, in the present specification, the term "graphene" may include not only pure graphene but also a graphene-based composite such as reduced graphene oxide.

Also, in the present specification, the term "vacuum region" refers to a region functioning as a channel for movement of charge carriers when gas density is relatively low compared to a normal atmospheric condition. The transistor device according to embodiments may be configured to operate in a vacuum state.

When the transistor operates in a vacuum state and a gate voltage is applied to the metalloid material of the emitter 40 through the gate structure 20, 50, electrons may be emitted from the tip B, which is an edge of the emitter 40, due to quantum tunneling. The transistor device according to embodiments is configured to adjust a Fermi level and a work function of the metalloid material through a gate voltage and thus adjust the number of emitted electrons, that is, the amount of current traversing the vacuum channel. The transistor device may be implemented as, for example, a three-terminal or four-terminal field-effect transistor (FET).

In an embodiment, the metalloid material of the emitter 40 has a 2D structure including a single layer or a plurality of layers. For example, the emitter 40 may have a flat plate shape with a thin and sharp edge. When the tip B of the emitter 40 has a sharp and pointed geometric structure, a charge distribution at the tip B is rearranged to compensate for an external electric field, thereby resulting in a locally increased charge density and a local field enhancement effect. The field enhancement effect induces quantum tunneling of electrons from the emitter 40 to the vacuum channel even when a relatively low gate voltage is applied.

A field enhancement effect may be induced by a structure with a radius of curvature less than or equal to a preset value, and for example, the field enhancement effect may occur at an edge of a 2D material with a thickness less than or equal to nanometers. Accordingly, a strong field enhancement effect may be obtained by using a material with high conductivity such as graphene as the emitter 40 with a 2D structure. Under a condition in which the same current density is applied, an electric field of a region adjacent to the tip B of the graphene emitter 40 is greater than that of conventional emitters having a greater radius of curvature, thereby increasing charge accumulation and a Fermi level at the tip B of the graphene emitter 40 and increasing emission current.

In an embodiment, an edge of the emitter 40 may be processed into a tapered shape in which a thickness of the emitter 40 decreases toward its end. However, a shape of the emitter 40 is not limited thereto, and in the present specification, a 2D shape of the emitter 40 may refer to a sheet shape in which a thickness is less than or equal to a certain level compared to a length and a width and a radius of curvature of an edge is sufficiently small.

In a conventional transistor device, an emitter having a flat plate shape has a disadvantage in that it is difficult to generate a high electric field compared to a structure having a sharp tip. On the other hand, in embodiments of the present disclosure, such a problem is solved by using an edge formed of a metalloid material with a 2D structure as the tip B of the emitter 40.

According to embodiments, when an FET is implemented by using an edge of flat graphene as the tip B of the emitter 40, because graphene is mechanically strong, the emitter 40 may not be destroyed or excessively deformed by Coulomb stress when a voltage is applied between the source electrode 10 and the channel. Also, because graphene is chemically inactive, molecules such as water and hydrocarbons, which may easily be adsorbed in low-temperature air, do not easily form strong chemical bonds with graphene, and such bonds may be removed through a process of heating to a certain temperature (e.g., 300°C or higher) in a vacuum state. Also, because graphene has very high electrical conductivity, large current may flow without causing excessive power dissipation.

Also, graphene forming the emitter 40 has high field emission current and transconductance because graphene has high electrical conductivity when suspended in a vacuum state; a temperature rise of the emitter 40 caused by field emission may be minimized because graphene has very high thermal conductivity; and because graphene has high heat dissipation, when combined with 2D structure characteristics, thermal loss due to thermal radiation is relatively large, thereby efficiently reducing a temperature difference with an adjacent medium forming surface contact.

In this case, due to the 2D structure of the graphene emitter, an electric field applied to the emitter tip decreases within a similar interval corresponding to a radius of curvature of the emitter tip. For example, because a radius of curvature (about 0.14 nm) of monolayer graphene is much smaller than a tunneling distance of electrons (about 1 nm), an electric field may dramatically decrease within an interval in which a vacuum level and a Fermi level of the graphene emitter tip become equal.

Also, a potential barrier for electron emission at the tip of the graphene emitter rapidly increases according to an angle with respect to a travel direction of emitted electrons, which reduces a ratio of emission current generated at large angles with respect to a graphene plane to total emission current. Although total energy of electrons inside graphene is the same as a sum of transverse energy and longitudinal energy, only the longitudinal component may be changed into RF power, and in the transistor device according to embodiments, emitted electrons hardly contain transverse energy, which is advantageous for the operation efficiency of the transistor.

Furthermore, in a graphene emitter with a 2D structure, electrons at or above a Fermi level have a much higher probability of quantum tunneling compared to an emitter with a greater radius of curvature, while electrons at or below a Fermi level have a much lower probability of quantum tunneling. This increase and decrease in tunneling probability depending on an energy level induces cooling due to emission of high-energy electrons from the emitter and reduces temperature rise due to emission of electrons at or below the Fermi level, thereby greatly lowering a crossover temperature at which the energy of field emission transitions from heating to cooling. The crossover temperature is a significant factor in determining a temperature of the emitter, and when graphene is used as the emitter, a reduction in the crossover temperature may prevent the durability of the emitter from being degraded caused by excessive temperature.

In an embodiment, an edge of the emitter 40 may be parallel to the surface of the substrate 100. In the cross-sectional view of FIG. 2, a region connecting the tip B of the emitter 40 to a conductive contact between the emitter 40 and the source electrode 10, that is, a channel region of the emitter 40, may be a straight line parallel to the substrate 100. However, this is only an example, and the emitter 40 may be curved in any direction as long as the emitter 40 conforms to a shape of the gate electrode 20.

In an embodiment, the tip B of the emitter 40 may protrude toward the drain electrode 30 compared to the gate structure 20, 50. Also, because the tip B of the emitter 40 is located within a vacuum channel region formed by partially removing the surface of the substrate 100, the tip B of the emitter 40 does not contact other components of the transistor device, such as the substrate 100, the gate insulating film 50, and the gate electrode 20. A position of the emitter 40 may be appropriately determined to minimize a probability that electrons emitted from the tip B contact other components, but when the tip B is too far from the gate electrode 20, a shielding effect on a gate voltage increases and controlling emission current becomes difficult, and thus, the position may be appropriately determined to achieve desired frequency response characteristics by applying a gate voltage.

However, in another embodiment, the tip B of the emitter 40 may be located at the same distance from the drain electrode 30 compared to the gate structure 20, 50.

Because the channel between the tip B of the emitter 40 with a 2D structure and the drain electrode 30 is in a vacuum, even when a gate voltage is applied to the emitter 40 in order to induce a field emission effect, dielectric breakdown does not occur, making it suitable as a medium for transmitting emitted electrons. This is different from conventional slid channel-based transistors in which only a small number of dielectric materials capable of withstanding a high electric field may be used as channel materials.

The gate structure 20, 50 refers to a structure for controlling electron emission by the emitter 40 by applying a gate voltage and modulating a work function of the emitter 40, and may include, for example, the gate insulating film 50 on the emitter 40 and the gate electrode 20 on the gate insulating film 50. The gate insulating film 50 may be formed of any of various dielectric materials such as oxide. The gate electrode 20 may efficiently modulate a Fermi level of the emitter 40 by applying a gate voltage of a voltage range in which dielectric breakdown of the gate insulating film 50 does not occur to a contact region (i.e., emitter channel region) between the gate insulating film 50 and the emitter 40. According to a shape of the gate insulating film 50, a shape of the emitter channel region may be a planar shape, a curved shape, or any arbitrary shape.

The drain electrode 30 is spaced apart from the emitter 40. For example, the drain electrode 30 may be disposed at a position horizontally displaced from the tip B of the emitter 40 along the surface of the substrate 100. A surface of the drain electrode 30 onto which current emitted from the emitter 40 is incident may or may not be completely perpendicular to the surface of the substrate 100.

In an embodiment, the tip B of the emitter 40 may protrude toward the drain electrode 30 by an interval $d_2$ relative to the gate structure 20, 50. Accordingly, a minimum distance $d_2$, $d_3$ between the gate structure 20, 50 and the drain electrode 30 is greater than a distance $d_3$ between the tip B of the emitter 40 and the drain electrode 30. Also, in this case, the distance $d_3$ between the tip B of the emitter 40 and the drain electrode 30 may be greater than the shortest distance $d_2$ between the tip B of the emitter 40 and the gate structure 20, 50.

For example, the distance $d_3$ between the tip B of the emitter 40 and the drain electrode 30 may be 300 nm, and the shortest distance $d_2$ between the tip B of the emitter 40 and the gate structure 20, 50 may be 100 nm. Also, in an embodiment, the shortest distance $d_2$ between the tip B of the emitter 40 and the gate structure 20, 50 may be 40 nm or less.

However, in another embodiment, the tip B of the emitter 40 may not protrude toward the drain electrode 30 compared to the gate structure 20, 50, and a shortest distance between the gate structure 20, 50 and the drain electrode 30 may be the same as the distance $d_3$ between the tip B of the emitter 40 and the drain electrode 30.

Also, in an embodiment, a length $l_1$ of the source electrode 10 and a length $l_3$ of the drain electrode 30 may be 400 nm, a length $l_2$ of the gate electrode 20 may be 100 nm, and a length L of the emitter 40 may be 1300 nm. Also, a width W of each of the source electrode 10, the gate electrode 20, and the drain electrode 30 may be 1300 nm. In the present specification, the term "length" refers to a size of each component along a movement direction of charge carriers through the channel, and "width" of each electrode refers to a size of each component along a direction orthogonal to the length direction. Also, in an embodiment, a shortest distance $d_1$ between the source electrode 20 and the gate structure 20, 50 may be 700 nm.

A thickness t of the gate insulating film 50 of the gate structure may be determined based on a distance between the emitter 40 and the gate electrode 20 at which a voltage applied by the gate electrode 20 on the gate insulating film 50 may modulate a work function of the emitter 40. For example, in an embodiment, the thickness t of the gate insulating film 50 may be 10 nm or less.

However, dimensions related to each component of the transistor device described in the present specification are only examples, and dimensions related to each component constituting the transistor device may be appropriately determined according to an operating condition such as input power or phase change for the transistor.

In an embodiment, the transistor device according to embodiments may be sealed in order to maintain a vacuum state. The sealing of the transistor device may be performed by using well-known or future-developed technology, and for example, the transistor device may be sealed in a vacuum state by using a getter (not shown) such as titanium or barium, but the present disclosure is not limited thereto. The transistor device having the vacuum channel may operate in the vacuum sealed state, and a degree of vacuum required for operation may be appropriately determined based on a mean free path of electrons in gas within a space through which emitted electrons travel, a chemical reaction that may occur through an interaction with the gas, or physical adsorption onto the emitter 40.

Also, in an embodiment, the transistor device according to embodiments may further include a conductive lead (not shown) for each of the source electrode 10, the gate electrode 20, and the drain electrode 30. The transistor device may be connected to a circuit capable of applying a voltage by using the lead electrically connected to each electrode of the vacuum sealed device, thereby operating as a vacuum channel FET. During operation, electrons are emitted from the emitter 40 to which a gate voltage is applied, traverse the vacuum channel due to quantum tunneling, and then are incident on the drain electrode 30.

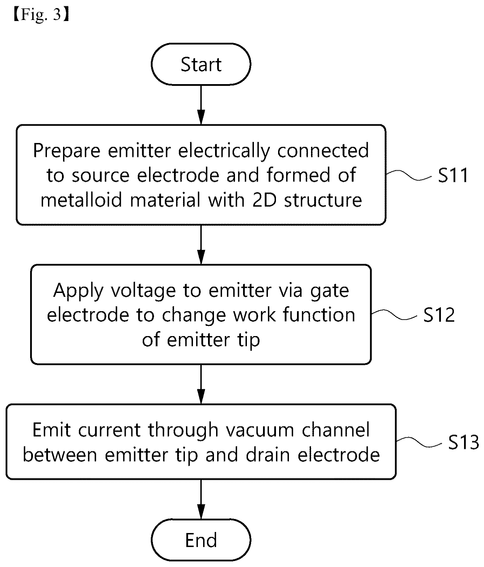

FIG. 3 is a flowchart illustrating each step of a method for operating a transistor device according to an embodiment. For convenience of explanation, the method for operating the transistor device according to the present embodiment will be described with reference to FIGS. 2 and 3.

First, as in the above embodiments, the transistor device including the source electrode 10 and the emitter 40 formed of a metalloid material with a 2D structure may be prepared (S1), and a work function of the tip B of the emitter 40 may be changed by applying a gate voltage to the emitter 40 by the gate electrode 20 (S12). As the work function of the tip B of the emitter 40 is changed, current may be emitted from the tip B of the emitter 40 due to quantum tunneling (S13), and the emitted current may traverse a vacuum channel between the tip B of the emitter 40 and the drain electrode 30 and may be incident on the drain electrode 30.

The operation of the transistor device described above is different from the operation of a conventional FET in which a gate electrode is located between an emitter and a drain electrode, in that the operation of the transistor device described above may be performed without introducing a field plate electrode for shielding and interfering with an electric field applied between the source electrode 10 and the drain electrode 30.

In an embodiment, a magnitude of a voltage applied by the gate electrode 20 to the emitter 40 in order to cause quantum tunneling of electrons varies according to quantum capacitance of the emitter 40, and the quantum capacitance of the emitter 40 is determined based on a voltage applied between the source electrode 10 and the drain electrode 30. Accordingly, a magnitude of a gate voltage for adjusting emission current of the emitter 40 may be determined by considering a magnitude of a source-drain voltage.

In an embodiment, a magnitude of a gate voltage applied by the gate electrode 20 may be greater than 0 V and less than or equal to 10 V. Also, in an embodiment, a magnitude of a gate voltage may be greater than 0 V and less than or equal to 7 V. Furthermore, in an embodiment, a magnitude of a gate voltage may be greater than 0 V and less than or equal to 5 V. A gate voltage applied by the gate electrode 20 may have a negative (-) value, and may be, for example, greater than or equal to -10 V and less than 0 V.

In an embodiment, a magnitude of a source-drain voltage may be greater than 0 V and less than or equal to 200 V. Also, in an embodiment, a magnitude of a source-drain voltage may be greater than 0 V and less than or equal to 100 V. Furthermore, in an embodiment, a magnitude of a source-drain voltage may be 90 V to 100 V.

According to the method for driving the transistor device according to embodiments described above, because a local field enhancement effect on a potential distribution of an adjacent space is induced at the tip B of the emitter 40 formed of a metalloid material with a 2D structure, quantum tunneling of electrons through the vacuum channel may be efficiently induced even when a relatively low voltage is applied.

In the transistor device according to embodiments, because an effect such as lattice scattering which may occur in a solid material-based channel does not exist in the vacuum channel where electrons emitted through quantum tunneling traverse due to an electric field, a velocity of the emitted electrons is not saturated. Also, due to high quantum capacitance resulting from the high electric conductivity and 2D structure of the emitter 40 formed of a metalloid material, the transistor device that may normally operate even at a high frequency of 100 GHz or more may be realized.

Also, in the transistor device according to embodiments, because a source-drain distance may be smaller than that of a conventional transistor device without a field plate electrode for shielding and interfering with an electric field applied between the source electrode 10 and the drain electrode 30, excellent operation performance may be achieved even at a high frequency.

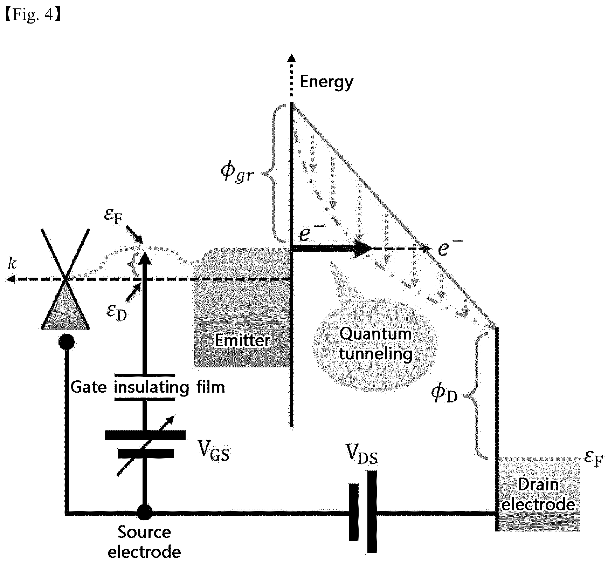

FIG. 4 is a conceptual diagram for describing an operation of a transistor device according to an embodiment.

Referring to FIG. 4, graphene constituting an emitter has a characteristic where a valence band and a conduction band meet at a charge neutrality point, causing a state density to 0. However, when a positive potential is applied to the graphene, electrons are accumulated in the graphene and a Fermi level increases to the conduction band, which locally reduces a potential barrier through quantum tunneling at a graphene tip and enables current emission through a vacuum channel.

More specifically, when a Fermi velocity of $10^6$ m/s is $\upsilon_F$, Planck constant of $6.58 \times 10^{-16}$ eV·s is h, and charge density is $\rho$, Fermi energy $E_F$ of graphene is defined by Equation 1.

[Equation 1]

$$E_F = h \upsilon_F \sqrt{\pi \rho}$$

The Fermi energy defined by Equation 1 rises very rapidly and steeply near an edge of the graphene, and more charges are accumulated at the edge of the graphene due to a 2D structure.

In particular, a transistor device according to embodiments may operate by using Fowler-Nordheim tunneling in which a local field enhancement effect is induced near an emitter tip due to a voltage applied to a drain electrode and an allowable band for emitted electrons in a vacuum channel is bent, drastically increasing a probability of quantum tunneling. The probability of quantum tunneling depends on a thickness of a potential barrier, and a width of the potential barrier from the perspective of emitted electrons depends on a position of a Fermi level at the emitter tip.

Accordingly, the probability of quantum tunneling may be controlled by applying a gate voltage and indirectly changing the Fermi level at the emitter tip with a gate insulating film therebetween, and as a result, tunneling current, that is, emission current, may be controlled. The current emitted from the graphene tip due to quantum tunneling may take the form of a sheet electron beam.

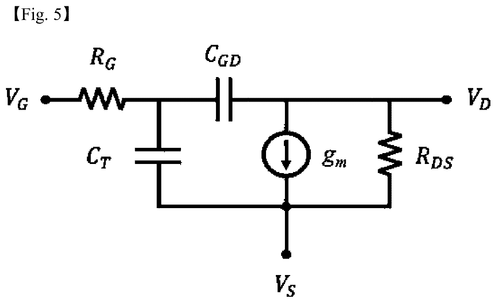

FIG. 5 is a diagram schematically illustrating an equivalent circuit structure of a vacuum channel FET in which a transistor device is implemented according to an embodiment.

In the equivalent circuit of FIG. 5, Vs, $V_G$, and $V_D$ respectively denote contact points of a source electrode, a gate electrode, and a drain electrode, and connection between an emitter formed of graphene and each electrode is equivalently represented by a small-signal model including capacitances $C_T$ and $C_{GD}$, resistances $R_G$ and $R_{DS}$, and transconductance $g_m$.

For convenience of calculation, the inventors calculated the equivalent circuit by assuming that a width of all devices is 1 mm, and when it was assumed that palladium is used as an electrode material of the gate electrode, the gate resistance $R_G$ is $3.51 \times 10^{-6}$ Ω. In this case, it was assumed that a thickness of the gate electrode is 1 nm and a length is 30 nm. The above parameter and material assumptions are only examples. Also, even when the gate electrode is formed of another material such as gold (Au), platinum (Pt), copper (Cu), aluminum (Al), tungsten (W), titanium (Ti), or silver (Ag), a similar estimation method may be applied.

The source-drain output resistance $R_{DS}$ is the inverse of output conductance (small change in emission current due to a drain voltage), and the source-drain output resistance $R_{DS}$ and the transconductance $g_m$ vary depending on a gate voltage because a value of emission current may vary according to a gate voltage. In the numerical assumptions for each device described above, the capacitance $C_{GD}$ of the gate insulating film is $1.7071 \times 10^{-14}$ F. Also, the total capacitance $C_T$ is a value considering a quantum capacitance value of graphene, and may be modeled as a series connection of capacitance $C_{GS}$ of the gate insulating film and quantum capacitance $C_Q$ of graphene and calculated by Equation 2.

[Equation 2]

$$\frac{1}{C_T} = \frac{1}{C_{GS}} + \frac{1}{C_Q}$$

For example, when it is assumed that hafnium oxide ($HfO_2$) is used as the gate insulating film, a height of the gate electrode is 5 nm, and a length of the gate electrode is 30 nm, the capacitance $C_{GS}$ of the gate insulating film is $1.32813 \times 10^{-12}$ F. Also, the quantum capacitance of graphene depends on a gate voltage and a source-drain voltage, is determined by a displacement of a Fermi level $\varepsilon_F$ from a Dirac level $\varepsilon_D$ in a band structure of graphene, and consequently varies according to each voltage condition. In an embodiment, the total capacitance $C_T$ calculated based on the above numerical assumptions may have a value of $10^{-12}$ to $10^{-13}$ F.

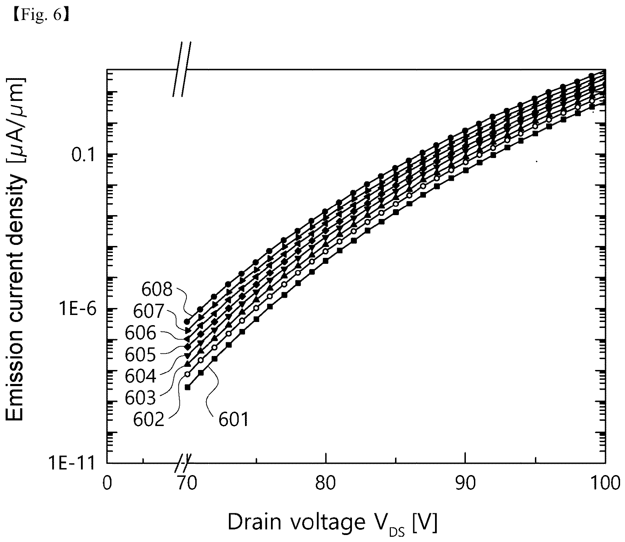

FIG. 6 is a graph illustrating current-voltage characteristics of a transistor device according to an embodiment, showing a change in emission current according to a gate voltage as a source-drain voltage changes from 0 V to 100 V. In this case, the gate voltage was increased from 0 V to 7 V at 1 V intervals, and emission current density according to the drain voltage is shown as a separate graph for each gate voltage. That is, eight graphs 601 to 608 respectively represent the emission current density when the gate voltage is 0 V, 1 V, 2 V, 3 V, 4 V, 5 V, 6 V, and 7V.

As shown in FIG. 6, the emission current of the transistor device tends to increase exponentially according to the change in the source-drain voltage, and the emission current may be adjusted by changing the gate voltage. Also, the change in the emission current is affected by a length of a vacuum channel that is a medium through which emitted electrons move, a distance between a gate structure and a tip of a graphene emitter, etc.

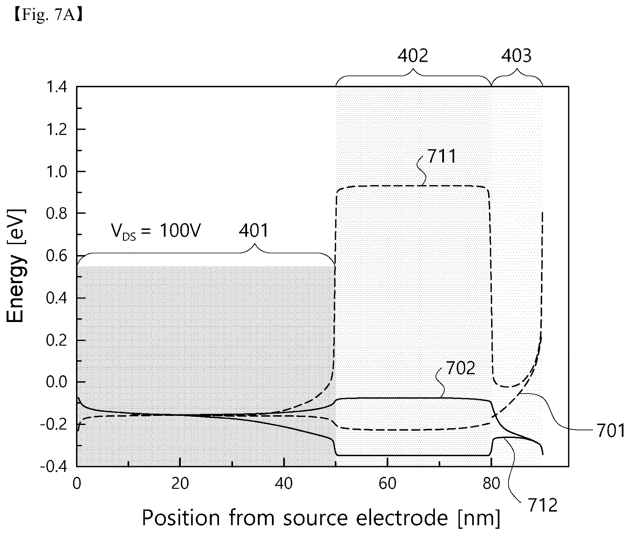

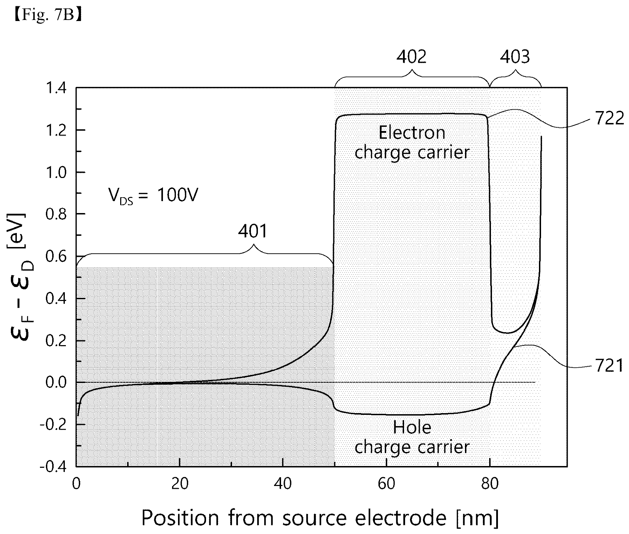

FIGS. 7A and 7B are graphs illustrating a change in a band structure of each region of an emitter according to a voltage condition applied to each of a source electrode, a drain electrode, and a gate electrode in a transistor device according to an embodiment.

FIG. 7A illustrates energy on a surface of a graphene emitter according to a position from a source electrode, and a conductive contact point between the source electrode and the graphene emitter becomes a reference point of the position. A region 401 in the graph refers to a graphene emitter channel region in which charge carriers move along graphene, a region 402 refers to a graphene emitter channel region located under a gate structure, and a region 403 refers to an edge of the graphene emitter.

In this case, FIG. 7A shows a distribution of a Dirac level $\varepsilon_D$ and a Fermi level $\varepsilon_F$ of each region of the emitter with a potential of the source electrode as a reference potential according to a magnitude of a gate voltage $V_G$. Graphs 701 and 702 show the Fermi level $\varepsilon_F$ and the Dirac level $\varepsilon_D$ when the gate voltage $V_G$ is 0 V, and graphs 711 and 712 show the Fermi level $\varepsilon_F$ and the Dirac level $\varepsilon_D$ when the gate voltage $V_G$ is 5 V.

FIG. 7B shows the energy distribution of FIG. 7A as a displacement of the Fermi level $\varepsilon_F$ from the Dirac level $\varepsilon_D$, and graphs 721 and 722 show a displacement when the gate voltage $V_G$ is 0 V and 5 V. Major charge carriers that dominate a graphene emitter channel may be identified through a relationship between energy levels of the Fermi level $\varepsilon_F$ and the Dirac level $\varepsilon_D$.

As shown in FIGS. 7A and 7B, a concentration of charge carriers induced within the graphene emitter channel is determined by a potential difference between the graphene emitter channel and the gate electrode. When the source-drain voltage $V_{DS}$ is 100 V and the gate voltage $V_G$ is 0 V, the Fermi level $\varepsilon_F$ remains at an energy level lower than the Dirac level $\varepsilon_D$ within the graphene emitter channel under a gate insulating film affected by the gate voltage $V_G$. In this case, charge carriers induced within the graphene emitter channel mainly include holes.

On the other hand, when the gate voltage $V_G$ is 5 V under the same condition, the Fermi level $\varepsilon_F$ remains at an energy level higher than the Dirac level $\varepsilon_D$, and thus, charge carriers induced within the graphene emitter channel mainly include electrons. The influence of the gate voltage $V_G$ on a graphene emitter tip is partially shielded by the induced charge carriers as described above. The shielded gate voltage $V_G$ affects the Fermi level $\varepsilon_F$ of the graphene emitter tip, and consequently, emission current from the emitter may be modulated by applying the gate voltage and adjusting the Fermi level $\varepsilon_F$ of the graphene emitter.

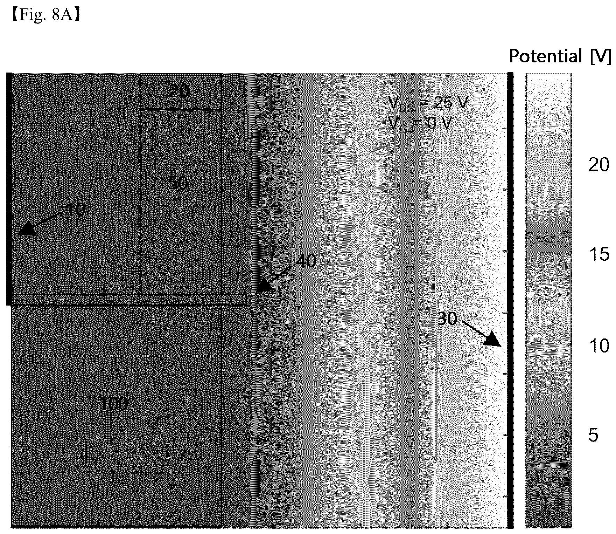

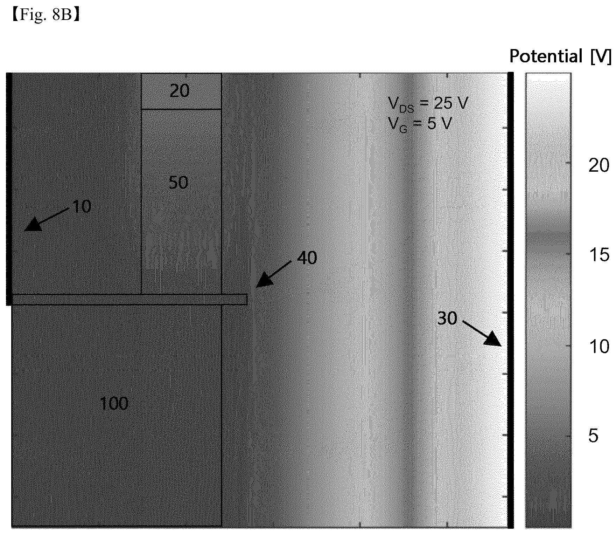

FIGS. 8A and 8B are graphs illustrating a potential distribution of a region of a device and an adjacent space according to a voltage condition applied to each of a source electrode, a drain electrode, and a gate electrode in a transistor device according to an embodiment.

A potential distribution in FIGS. 8A and 8B shows a state where a source-drain voltage is 25 V, and FIG. 8A illustrates a state where a gate voltage is 0 V and FIG. 8B illustrates a state when the gate voltage is 5 V. As shown, an electric field formed in a vacuum channel by the source-drain voltage is formed so that emitted electrons fully move to the drain electrode.

In the transistor device according to embodiments, because the gate electrode does not exist in the vacuum channel unlike a conventional vacuum channel transistor, electrons emitted from an emitter may be fundamentally prevented from entering and leaking through the gate electrode.

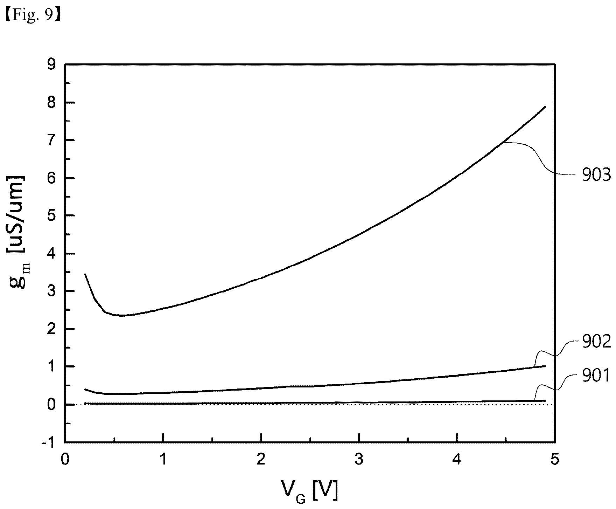

FIG. 9 is a graph illustrating a change in transconductance according to a change in a gate voltage in each source-drain voltage condition in a transistor device according to an embodiment, showing a transconductance value according to a magnitude of the gate voltage when the source-drain voltage $V_{DS}$ changes to 90 V, 95 V, and 100 V. That is, graphs 901 to 903 of FIG. 9 illustrate the transconductance value when the source-drain voltage $V_{DS}$ is 90 V, 95 V, and 100 V.

Referring to FIG. 9, like emission current, transconductance of a graphene emitter varies exponentially according to a change in the source-drain voltage $V_{DS}$. Also, transconductance also varies according to a change in the gate voltage $V_G$, which depends on a concentration of charge carriers induced by the gate voltage.

A point at which the transconductance value is a minimum value is a point (charge neutrality point) at which a Fermi level displaced by the applied gate voltage $V_G$ coincides with a Dirac level of a graphene emitter channel and the concentration of induced charge carriers becomes 0. As a degree of separation between the Fermi level and the Dirac level decreases, quantum capacitance decreases, and a degree to which a slight displacement of the Fermi level in the graphene emitter channel is induced by the gate voltage $V_G$ also decreases. As the gate voltage $V_G$ changes from 0 V to 5 V, the transconductance reaches a minimum value and then increases again. Such a change is also affected by the concentration of charge carriers induced by the source-drain voltage $V_{DS}$.

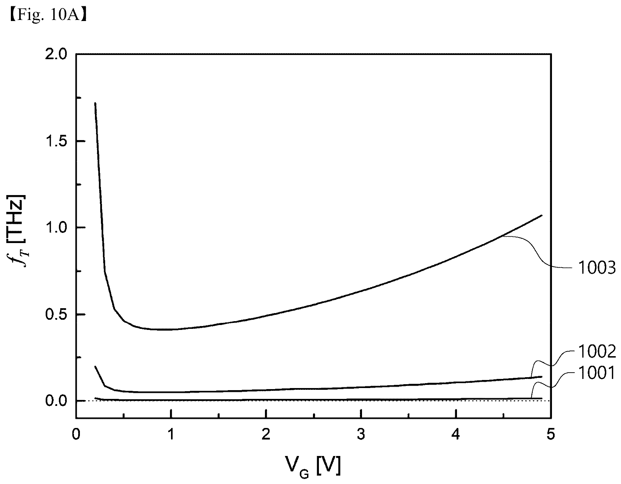

FIG. 10A is a graph illustrating a change in a cutoff frequency $f_T$ according to a change in a gate voltage in each source-drain voltage condition in a transistor device according to an embodiment.

When the transistor device according to the present embodiment is applied to the equivalent circuit described with reference to FIG. 5, the cutoff frequency $f_T$ may be calculated based on the transconductance $g_m$, the gate insulating film capacitance $C_{GD}$, and the total capacitance $C_T$ as shown in Equation 3.

[Equation 3]

$$f_T = \frac{g_m}{2\pi(C_T + C_{GD})}$$

Graphs 1001 to 1003 of FIG. 10A illustrate the cutoff frequency $f_T$ when the source-drain voltage $V_{DS}$ is 90 V, 95 V, and 100 V. The cutoff frequency fr according to the gate voltage $V_G$ of FIG. 10A changes in a similar manner to the transconductance value described with reference to FIG. 9. For example, when the source-drain voltage $V_{DS}$ is 90 V, the cutoff frequency is $3.66 \times 10^{-3}$ to $1.44 \times 10^{-2}$ THz. When the source-drain voltage $V_{DS}$ is 95 V, the cutoff frequency is $4.8 \times 10^{-2}$ to $1.96 \times 10^{-1}$ THz. When the source-drain voltage $V_{DS}$ is 100 V, the cutoff frequency is $4.1 \times 10^{-1}$ to 1.72 THz. These values of the cutoff frequency $f_T$ are substantially greater than those of conventional transistor devices that transport charge carriers through a solid-state channel.

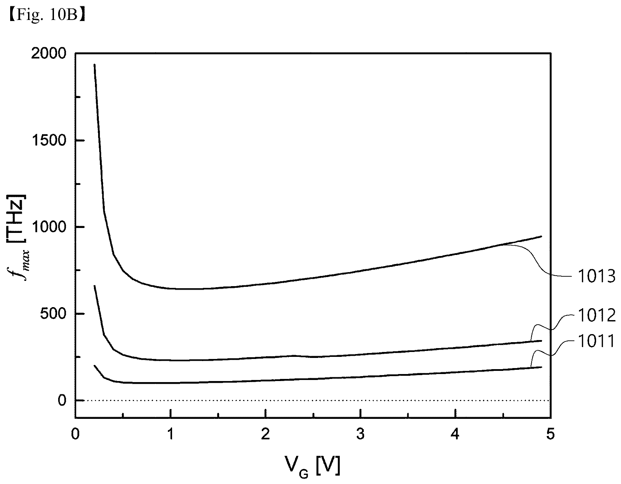

FIG. 10B is a graph illustrating a change in a maximum oscillation frequency according to a change in a gate voltage in each source-drain voltage condition in a transistor device according to an embodiment.

When the transistor device according to the present embodiment is applied to the equivalent circuit described with reference to FIG. 5, a maximum oscillation frequency $f_{max}$ may be calculated based on the transconductance $g_m$, the gate insulating film capacitance $C_{GD}$, the total capacitance $C_T$, the gate resistance $R_G$, and the source-drain output resistance $R_{DS}$ as shown in Equation 4.

[Equation 4]

$$f_{\max} = \frac{g_m}{2\pi C_T} \frac{1}{\sqrt{\dfrac{R_G}{R_{DS}} + g_m R_G \dfrac{C_{GD}}{C_T}}}$$

Graphs 1011 to 1013 of FIG. 10B illustrate the maximum oscillation frequency $f_{max}$ when the source-drain voltage $V_{DS}$ is 90 V, 95 V, and 100 V. The maximum oscillation frequency $f_{max}$ according to the gate voltage $V_G$ of FIG. 10B varies in a similar manner to the transconductance value described with reference to FIG. 9. For example, when the source-drain voltage $V_{DS}$ is 90 V, the maximum oscillation frequency $f_{max}$ is 99 to 201 THz. When the source-drain voltage $V_{DS}$ is 95 V, the maximum oscillation frequency $f_{max}$ is 230 to 661 THz. When the source-drain voltage $V_{DS}$ is 100 V, the maximum oscillation frequency $f_{max}$ is 641 to 1940 THz. These values of the maximum oscillation frequency $f_{max}$ are substantially greater than those of conventional transistor devices that transport charge carriers through a solid-state channel.

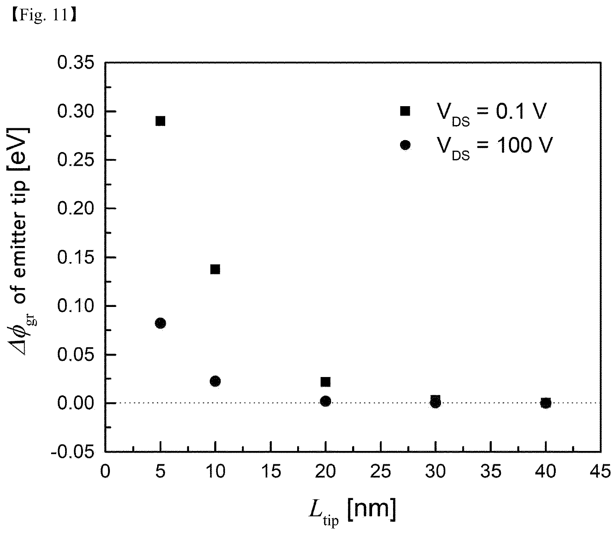

FIG. 11 is a graph illustrating a change in a work function of an emitter tip according to a change in a shortest distance between a gate electrode and the emitter tip, a source-drain voltage condition, and modulation of a gate voltage in a transistor device according to an embodiment.

In the transistor device according to embodiments, a shielding effect by charge carriers induced within a graphene emitter channel affects an operation of the device. The shielding effect is determined by charge carriers induced by the gate voltage and charge carriers induced by the source-drain voltage $V_{DS}$, and as the tip of the graphene emitter from which electrons are emitted is farther away from a gate structure, a total amount of charges existing between the two regions increases and the shielding effect increases.

As a result, as shown in FIG. 11, as a length $L_{tip}$ between a source electrode and the emitter tip increases, a work function change $\Delta\Phi_{gr}$ of the graphene emitter tip according to a change in the gate voltage decreases dramatically. Also, a difference in a width of the work function change $\Delta\Phi_{gr}$ of the graphene emitter tip according to a change in the source-drain voltage $V_{DS}$ depends on a change in quantum capacitance within the graphene emitter channel.

When the source-drain voltage $V_{DS}$ is small, a degree of displacement of a Fermi level of the graphene emitter tip is small, quantum capacitance of the emitter is small, and thus, the width of the work function change $\Delta\Phi_{gr}$ of the graphene emitter tip due to the gate voltage increases. In contrast, when the source-drain voltage $V_{DS}$ is large, a degree of displacement of the Fermi level of the graphene emitter tip is large, and thus, the width of the work function change $\Delta\Phi_{gr}$ of the graphene emitter tip due to the gate voltage relatively decreases.

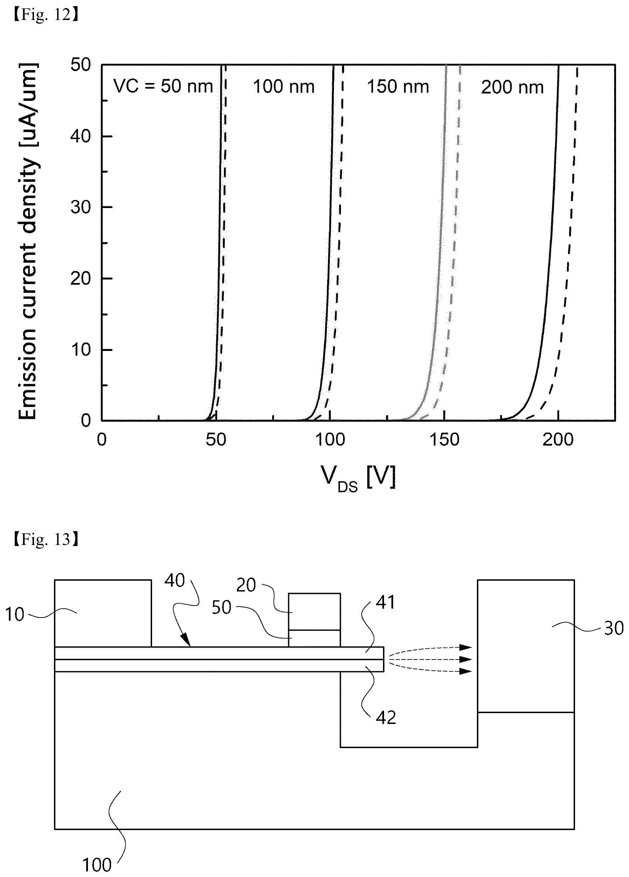

FIG. 12 is a graph illustrating current-voltage characteristics when a length of a vacuum channel changes in a transistor device according to an embodiment.

FIG. 12 illustrates current-voltage characteristics of the transistor device when a length VC of a vacuum channel in a device structure changes to 50 nm, 100 nm, 150 nm, and 200 nm. In this case, the source-drain voltage $V_{DS}$ is 100 V, a solid line in the graph indicates emission current density when a gate voltage in the vacuum channel having each length is 5 V, and a dashed line indicates a change in an emission current value when the gate voltage in the vacuum channel having each length is 0 V.

As shown in FIG. 12, as the length VC of the vacuum channel increases, an electric field applied to a graphene emitter edge by the source-drain voltage $V_{DS}$ decreases. Accordingly, even when the same source-drain voltage $V_{DS}$ is applied, as the length of the vacuum channel VC increases, the emission current value decreases exponentially.

Furthermore, a threshold voltage at which emission current exponentially increases also changes depending on the length VC of the vacuum channel. Also, when the length VC of the vacuum channel increases, the electric influence on charge carriers induced within the graphene emitter channel decreases, and a concentration of charge carriers induced by a change in the gate voltage relatively increases. Accordingly, it is found that as the length VC of the vacuum channel increases, a difference in the emission current between gate voltage on and off states increases.

FIG. 13 is a cross-sectional view illustrating a transistor device using a metalloid material with a 2D structure as an emitter according to still another embodiment.

The transistor device according to an embodiment of FIG. 13 is different from the embodiment described with reference to FIGS. 1 and 2 in that the emitter 40 has a double layer of graphene 41, 42, and thus, to avoid a repeated description, other components than the emitter 40 will not be described. As shown, in the present embodiment, the emitter 40 includes a first layer 41 and a second layer 42 formed of graphene or reduced graphene oxide. The second layer 42 may be located on the substrate 100, the first layer 41 may be located on the second layer 42, and the gate structure including the gate insulating film 50 and the gate electrode 20 may be located on the first layer 41.

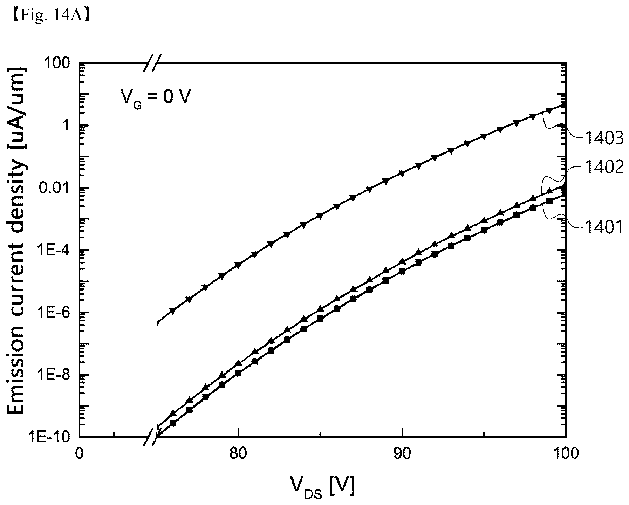

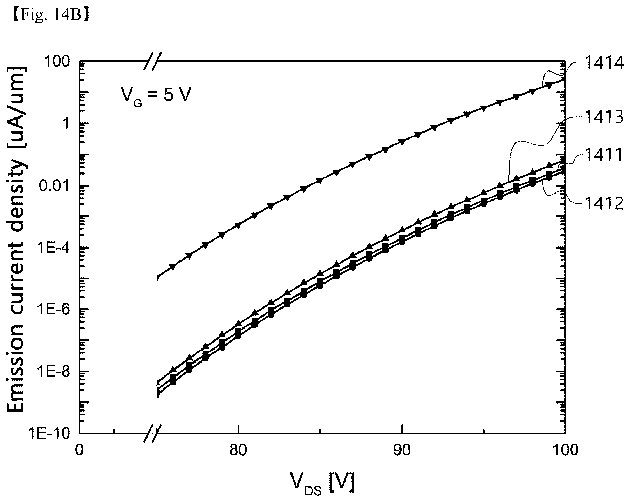

FIGS. 14A and 14B are graphs illustrating current-voltage characteristics according to a voltage condition applied to each of a source electrode, a drain electrode, and a gate electrode in the transistor device of FIG. 13. FIG. 14A illustrates emission current density according to a change in the source-drain voltage $V_{DS}$ when the gate voltage $V_G$ is 0 V, and a graph 1401 of FIG. 14 illustrates emission current density of graphene first layer and second layer, a graph 1402 illustrates emission current density of an entire graphene double layer, and a graph 1403 illustrates emission current density of a graphene single layer. FIG. 14B illustrates emission current density according to a change in the source-drain voltage $V_{DS}$ when the gate voltage $V_G$ is 5 V. Graphs 1411 and 1412 of FIG. 14B illustrate emission current density of graphene first layer and second layer, a graph 1413 illustrates emission current density of an entire graphene double layer, and a graph 1414 illustrates emission current density of a graphene single layer.

Referring to FIGS. 14A and 14B, it is found that an emission current density value is reduced when the graphene double layer is used as an emitter when compared to a case where the graphene single layer is used as an emitter. This is because a shielding effect occurs between two graphene layers in the graphene double layer constituting the emitter, and a concentration of charge carriers induced by the source-drain voltage $V_{DS}$ and the gate voltage $V_G$ is relatively reduced, leading to a reduction in emission current.

In detail, when the gate voltage $V_G$ is applied to the emitter including the graphene double layer, charge carriers are induced by an external voltage in both layers of the graphene double layer. In this case, due to a shielding effect by charge carriers induced in a graphene layer (the first layer 41; see FIG. 13) contacting a gate insulating film, a concentration of charge carriers induced in a graphene layer (the second layer 42; see FIG. 13) contacting a substrate is relatively reduced. Accordingly, a change in a charge carrier concentration in the graphene double layer according to a change in the gate voltage $V_G$ and a resultant change in emission current are different between the layers (41, 42; see FIG. 13) constituting the double layer.

However, even when the emitter includes the graphene double layer, emission current still tends to exponentially increase according to a change in the source-drain voltage $V_{DS}$. Also, it is found that the emission current may be adjusted according to a change in the gate voltage $V_G$. Although embodiments including emitters including a single layer and a double layer are illustrated in the present specification, the emitter may include three or more layers according to an embodiment.

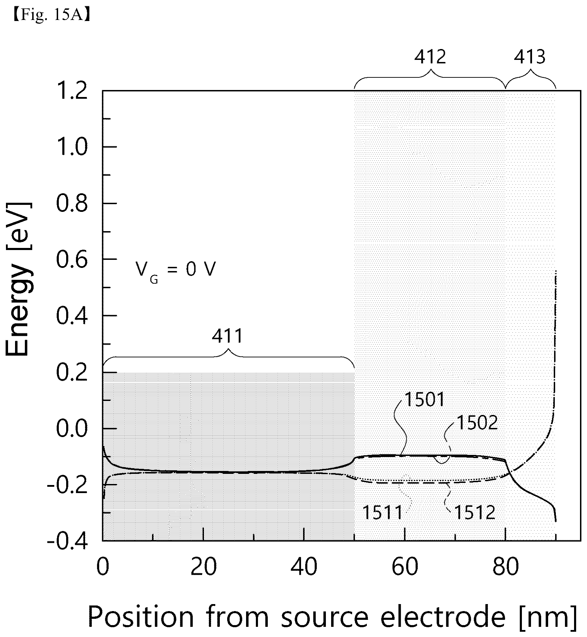

FIGS. 15A to 15C are graphs illustrating a change in a band structure of each region of an emitter according to a voltage condition applied to each of a source electrode, a drain electrode, and a gate electrode in the transistor device of FIG. 13.

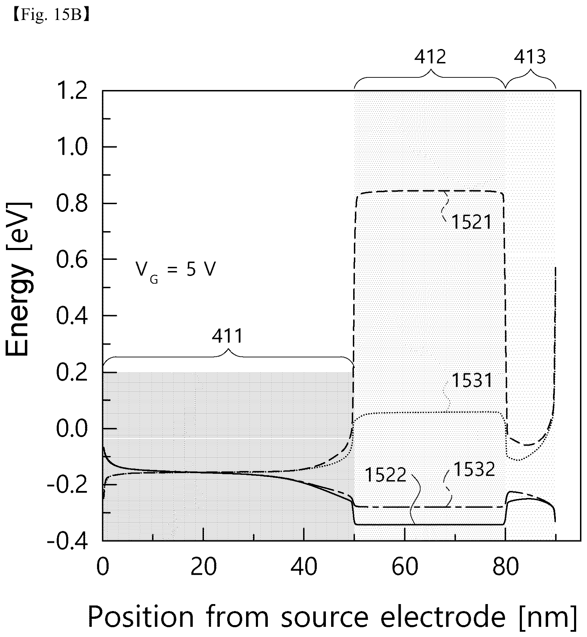

FIG. 15A illustrates an energy band when the source-drain voltage $V_{DS}$ is 100 V and the gate voltage $V_G$ is 0 V, and graphs 1501 and 1502 illustrate a Fermi level $\varepsilon_F$ and a Dirac level $\varepsilon_D$ of a graphene first layer, and graphs 1511 and 1512 illustrate a Fermi level $\varepsilon_F$ and a Dirac level $\varepsilon_D$ of a graphene second layer. Also, FIG. 15B illustrates an energy band when the source-drain voltage $V_{DS}$ is 100 V and the gate voltage $V_G$ is 5 V, and graphs 1521 and 1522 illustrate a Fermi level $\varepsilon_F$ and a Dirac level $\varepsilon_D$ of a graphene first layer, and graphs 1531 and 1532 illustrate a Fermi level $\varepsilon_F$ and a Dirac level $\varepsilon_D$ of a graphene second layer.

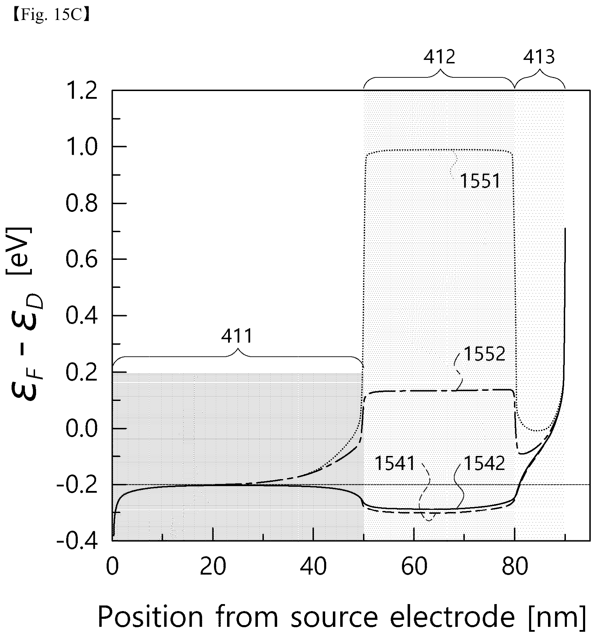

FIG. 15C illustrates a degree to which the Fermi level $\varepsilon_F$ is displaced from the Dirac level $\varepsilon_D$ in each graphene layer (i.e., the first layer 41 and the second layer 42; see FIG. 13) constituting the emitter when the gate voltage $V_G$ is 0 V and 5 V. Graphs 1541 and 1542 illustrate a displacement of the Fermi level $\varepsilon_F$ from the Dirac level $\varepsilon_D$ in the graphene first layer and second layer when the gate voltage $V_G$ is 0 V, and graphs 1551 and 1552 illustrate a displacement of the Fermi level $\varepsilon_F$ from the Dirac level $\varepsilon_D$ in the graphene first layer and the second layer when the gate voltage $V_G$ is 5 V.

As shown in FIG. 15C, a polarity and a concentration of charge carriers induced within a graphene emitter channel are determined by a potential difference between the graphene emitter channel and the gate electrode. When the gate voltage $V_G$ is 0 V, the Fermi level $\varepsilon_F$ in the graphene double layer channel under a gate insulating film remains at an energy level lower than the Dirac level $\varepsilon_D$. In this case, charge carriers induced within the graphene emitter channel mainly include holes. On the other hand, when the gate voltage $V_G$ is 5 V, the Fermi level $\varepsilon_F$ remains at an energy level higher than the Dirac level $\varepsilon_D$, and thus, charge carriers induced within the graphene emitter channel mainly include electrons.

Also, when a relatively large gate voltage $V_G$ is applied, a concentration of charge carriers induced in a lower layer (i.e., the second layer 42 adjacent to the substrate; see FIG. 13) of the graphene double layer is less than a concentration of charge carriers induced in an upper layer (i.e., the first layer 41 adjacent to the gate insulating film; see FIG. 13) of the graphene double layer adjacent to the gate insulating film. This is due to a shielding effect caused by the charge carriers induced in the upper layer.

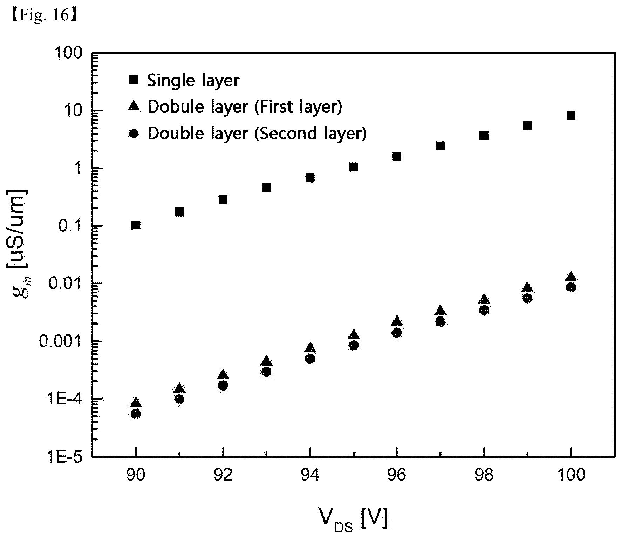

FIG. 16 is a graph illustrating a change in the transconductance $g_m$ according to a change in the gate voltage $V_G$ in each source-drain voltage ($V_{DS}$) condition in the transistor device of FIG. 13.

For performance comparison of frequency characteristics, a transconductance value when a graphene single layer emitter was used is also illustrated. The source-drain voltage $V_{DS}$ was increased from 90 V to 100 V at 1 V intervals, and in this case, the gate voltage $V_G$ is 5 V. It is found that the transconductance $g_m$ when an emitter includes a double layer of graphene is lower than that when an emitter includes single layer graphene. This indicates that, in the emitter including the double layer, a shielding effect between layers of the double layer affects not only the amount of emission current but also frequency characteristics of the emitter.

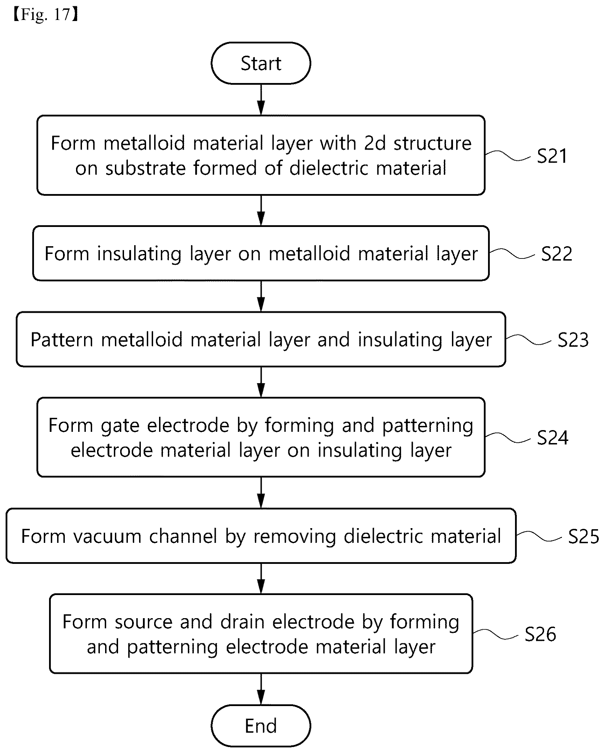

FIG. 17 is a flowchart illustrating each step of a method for manufacturing a transistor device according to an embodiment.

A transistor device according to embodiments may be manufactured by sequentially forming, in an appropriate order, a gate insulating film, a gate electrode, an emitter, a source electrode, and a drain electrode on a substrate to form a layer structure as described with reference to FIGS. 1, 2, and 13. Also, during the process of manufacturing the transistor device according to embodiments, a part or the whole of the layer structure may be removed by using a method such as etching in order to implement structures and characteristics for achieving a function of the transistor device.

Referring to FIG. 17, in a method for manufacturing a transistor device according to an embodiment, a metalloid material with a 2D structure may be formed on a substrate having a surface formed of a dielectric material (S21). In the present specification, when a material or layer is formed, it is intended to include both a case where the material is directly formed on a substrate by using a method such as deposition or growth and a case where the material or layer is formed on a separate substrate and then is transferred. For example, a graphene emitter may be formed by depositing the graphene emitter on a separate substrate so that molecules (e.g., an edge of an armchair structure) in an appropriate direction become a tip and then transferring the graphene emitter, but the present disclosure is not limited thereto.

In operation S21, the substrate may include an optically flat and smooth dielectric material, for example, silicon nitride ($Si_3N_4$) or may include such a dielectric material on the surface. In an embodiment, it is preferable that the dielectric material used to form the substrate or provided on the substrate is a material with low reactivity with a material for etching a gate insulating film material (e.g., hafnium oxide ($HfO_2$)) to be formed later. Likewise, it is preferable that the gate insulating film is formed of a material with low reactivity with a material for etching the dielectric material of the substrate.

Next, an insulating layer formed of a dielectric material for forming a gate insulating film may be formed on the metalloid material layer by using an arbitrary method such as growth or deposition (S22), and an emitter and a gate insulating film may be formed by patterning the metalloid material layer and the insulating layer (S23). A method of patterning the material layer may be performed by a conventional lithography method in which a photoresist is coated on the metalloid material and the insulating layer, an unnecessary portion is removed by using etching or the like after leaving only a necessary region through exposure and development processes, and finally, the photoresist is removed.

Although the metalloid material layer and the insulating layer are patterned in one operation S23 in FIG. 17, this is only an example for convenience of explanation, and each layer may be separately patterned according to a material or a process condition required for the layer.

Next, an electrode material layer may be formed on the gate insulating film by using a well-known process such as photoresist coating, exposure, and development, and a gate electrode may be formed by patterning the electrode material layer (S24). For example, the electrode material layer for forming the gate electrode may be formed by forming the electrode material layer and removing an unnecessary photoresist and a metal layer through a lift-off process, leaving only the gate electrode, but the present disclosure is not limited thereto.

Next, etching may be performed on the dielectric material to form a vacuum channel (S25). Although the metalloid material layer is first patterned in operation S23 in FIG. 17, in another embodiment, the metalloid material layer may be patterned together in operation S25 in which the dielectric material for forming the vacuum channel is etched. In this case, the etching may be performed on the dielectric material by inducing an undercut for the metalloid material so that a tip of the metalloid material layer protrudes in the vacuum channel. In operation S25, in order to prevent the metalloid material with the 2D structure from being deformed and attached to the substrate, the etching on the dielectric material may be performed using gas-phase etching, wet etching using a critical point dryer together, or any other etching method.

Next, a source electrode contacting the metalloid material layer and a drain electrode spaced apart from the tip of the metalloid material with the vacuum channel therebetween may be formed by forming and patterning an electrode material layer on the substrate (S26). For example, the source electrode and the drain electrode may be formed by depositing the electrode material layer such as palladium (Pd) in a direction perpendicular to the surface of the substrate by using a method such as electron beam evaporation or thermal evaporation, but the present disclosure is not limited thereto. In this case, the drain electrode does not physically and electrically contact the tip of the metalloid material layer due to the undercut formed in operation S25. Also, the drain electrode is formed to a height that reaches the same level as the tip of the metalloid material layer from the surface of the substrate.

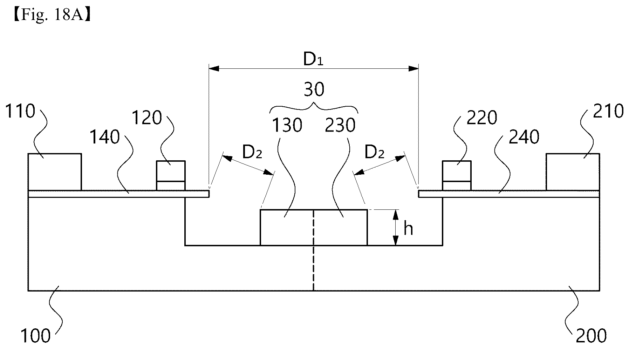

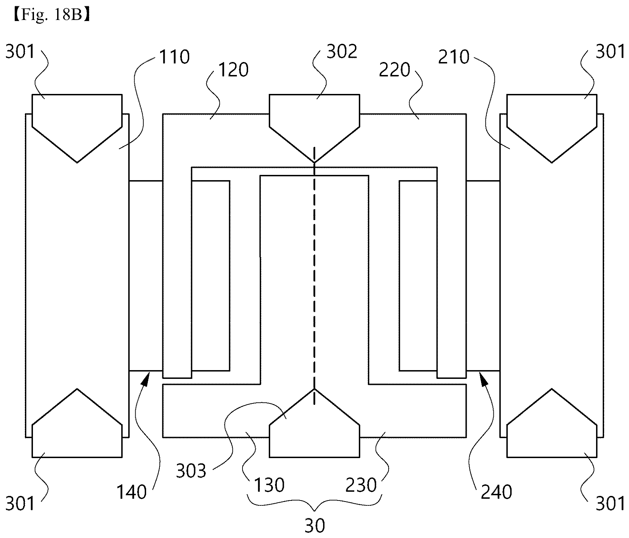

FIG. 18A is a cross-sectional view illustrating a transistor device according to still another embodiment, and FIG. 18B is a plan view illustrating the transistor device of FIG. 18A.

Referring to FIGS. 18A and 18B, in the transistor device in the present embodiment, one pair of transistor devices according to the embodiment described with reference to FIGS. 1 and 2 are arranged to face each other so that electron emission directions are opposite to each other. In the description of the transistor device according to the present embodiment, each transistor including an emitter, a source electrode, a drain electrode, and a gate structure is referred to as a "transistor element" for distinction, and a structure in which a plurality of transistor elements are combined is referred to as a "transistor device" according to the present embodiment.

A first transistor element 1 of the transistor device includes an emitter 140, a source electrode 110, a drain electrode 130, and a gate electrode 120. The first transistor element 1 may be manufactured on a first substrate 100. Likewise, a second transistor element 2 includes an emitter 240, a source electrode 210, a drain electrode 130, and a gate electrode 220. The second transistor element 2 may be manufactured on a second substrate 200. A gate insulating film may be located the gate electrode 120, 220 and the substrate. Also, a conductive lead 301 may be electrically connected to the source electrode 110, 210, a conductive lead 302 may be electrically connected to the gate electrode 120, 220, and a conductive lead 303 may be electrically connected to the drain electrode 130, 230.

A detailed configuration of each transistor element 1, 2 may be easily understood from the above embodiments, and thus, a detailed description thereof will be omitted.

One pair of transistor elements 1, 2 are arranged to face each other so that electron emission directions, that is, directions from the emitter 140, 240 toward the drain electrode 130, 230, are opposite to each other. The drain electrode 130 of the first transistor element 1 and the drain electrode 230 of the second transistor element 2 may be disposed adjacent to each other, may be spaced apart from each other by a slight gap, or may be in direct contact with each other. In an embodiment, the drain electrode 130 of the first transistor element 1 and the drain electrode 230 of the second transistor element 2 may be formed as one integrated drain electrode 30. Also, in an embodiment, the gate electrode 120 of the first transistor element 1 and the gate electrode 220 of the second transistor element 2 may be formed as one integrated electrode.

In an embodiment, the size and arrangement of each transistor element 1, 2 may be determined so that a shortest distance $D_1$ between a tip of the emitter 140 of the first transistor element 1 and a tip of the emitter 240 of the second transistor element 2 is about several micrometers.

Also, in an embodiment, a distance $D_2$ between an edge of the emitter 140, 240 and the drain electrode 130, 230 may be adjusted by adjusting a rate at which the drain electrode 130, 230 is formed on each substrate 100, 200. For example, the drain electrode 130, 130 on each substrate 100, 200 may be formed at a height (h) lower than a top surface of the emitter 140, 240. For example, the height (h) of the drain electrode 130, 230 may be determined so that a top surface of the drain electrode 130, 230 is 0 to 100 nm lower than the top surface of the emitter 140, 240.

As the height (h) of the drain electrode 130, 230 from the substrate 100, 200 decreases, the distance $D_2$ between the edge of the emitter 140, 240 and the drain electrode 130, 230 may increase. Accordingly, a vacuum channel having a desired length may be formed by finely adjusting a vertical formation rate of the drain electrode 130, 230 to an angstrom level, and in this case, a horizontal dimension (e.g., the length $l_3$ of FIG. 1) of the drain electrode 130, 230 may be more delicately adjusted.

In the transistor device according to the embodiment of FIGS. 18A and 18B, because one pair of transistor elements 1, 2 are arranged in opposite directions, when structures of both the transistor elements 1, 2 are perfectly symmetrical, a resultant electromagnetic force applied to the drain electrodes 130, 230 becomes 0. Also, even when both the transistor elements 1, 2 are not perfectly symmetrical to each other, because the transistor elements 1, 2 face each other, physical forces applied to the drain electrodes 130, 230 are considerably offset. Accordingly, in the transistor device according to the present embodiment, peeling of the drain electrodes 130, 230 due to electromagnetic forces may be prevented.

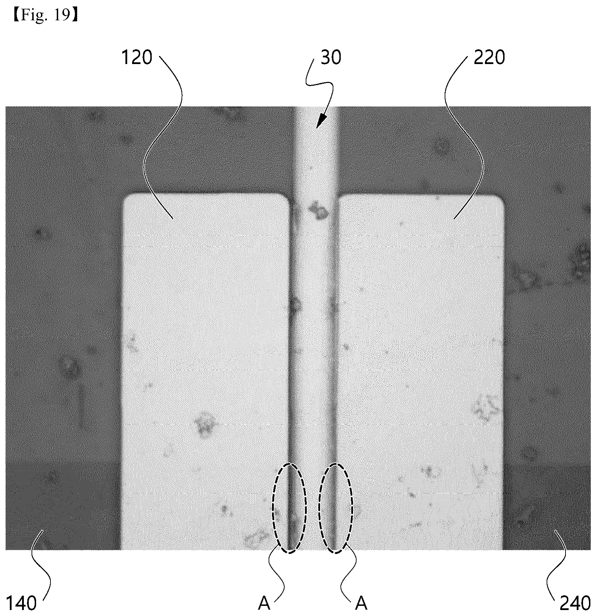

FIG. 19 is an optical microscope image of the transistor device manufactured according to the embodiment of FIGS. 18A and 18B. The inventors formed the gate electrode 120, 220 and the drain electrode 30 by depositing 10 nm of chromium and then depositing 140 nm of copper, and formed a vacuum channel by performing etching on a substrate by using tetrafluoromethane ($CF_4$) gas. In this case, a gap portion A between the emitter 140, 240 formed of graphene and the drain electrode 30 is a region where electron emission occurs.

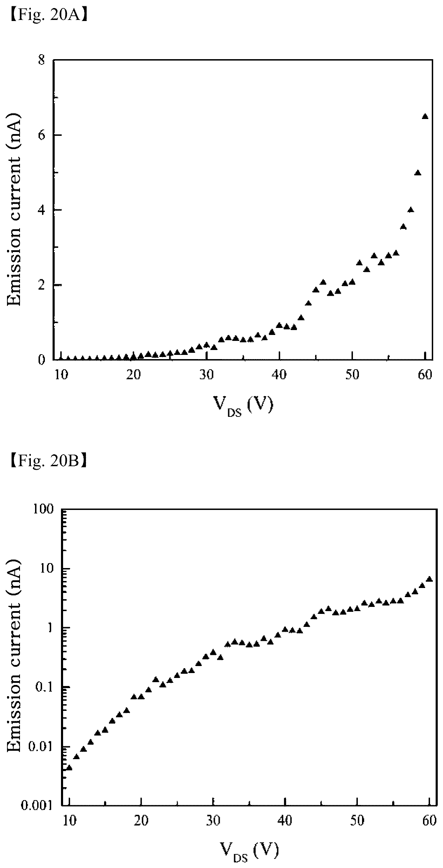

FIGS. 20A and 20B are graphs illustrating a result of manufacturing the transistor device according to the embodiment of FIGS. 18A and 18B and then measuring emission current by applying a voltage between a source electrode and a drain electrode. FIG. 20A illustrates that the emission current turns on after exceeding a threshold voltage and then begins to increase exponentially. 20B is a graph illustrating a current-voltage change of FIG. 20A on an exponential scale along the y-axis. This comparison is commonly used to clearly show that the current is a result of field emission due to a quantum tunneling effect. As shown in the two graphs, it was found through the graphs that a change in current is based on a quantum tunneling effect, rather than a resistive current change. Accordingly, according to embodiments of the present disclosure, it is found that a transistor device may be implemented by forming the transistor device in a structure parallel to a substrate and using an edge of a metalloid material such as graphene as a tip of an emitter.

While the present disclosure has been particularly shown and described with reference to embodiments thereof, they are provided for the purposes of illustration and it will be understood by one of ordinary skill in the art that various modifications and equivalent other embodiments may be made from the present disclosure. It should be understood that such modifications are included in the technical scope of the present disclosure. Accordingly, the true technical scope of the present disclosure should be determined by the technical spirit of the appended claims.

**Claims**

1. A transistor device comprising:

   an emitter located on a substrate comprising a dielectric material, the emitter being formed of a metalloid material with a two-dimensional (2D) structure and configured to selectively emit electrons;
   a source electrode electrically contacting a portion of the emitter;
   a drain electrode located on the substrate, spaced apart from the emitter, and electrically separated from the source electrode; and
   a gate structure located on the emitter and configured to apply a gate voltage for controlling electron emission by the emitter to the emitter by modulating a work function of the emitter.

2. The transistor device according to claim 1, wherein, when a gate voltage and a drain voltage are applied to the emitter so that the emitter emits electrons, a vacuum channel through which electrons are movable is formed between a tip of the emitter toward the drain electrode and the drain electrode.

3. The transistor device according to claim 2, wherein a distance between the gate structure and the drain electrode is greater than or equal to a distance between the tip of the emitter and the drain electrode.

4. The transistor device according to claim 3, wherein

   the tip of the emitter protrudes toward the drain electrode relative to the gate structure, and
   a shortest distance between the tip of the emitter and the gate structure is 40 nm or less.

5. The transistor device according to claim 2, wherein the 2D structure of the metalloid material is parallel to a surface of the substrate,
   wherein the emitter is configured to emit electrons from the tip of the emitter in a direction parallel to the surface of the substrate.

6. The transistor device according to claim 2, wherein the tip of the emitter has a radius of curvature less than or equal to a preset value so that a field enhancement effect is induced at the tip of the emitter by a voltage between the source electrode and the drain electrode.

7. The transistor device according to claim 1, wherein the emitter comprises one or more layers formed of graphene or reduced graphene oxide.

8. The transistor device according to claim 1, wherein the gate structure comprises:

   a gate insulating film located on the emitter; and
   a gate electrode located on the gate insulating film and configured to apply the gate voltage.

9. The transistor device according to claim 8, wherein the gate electrode is configured to apply a first voltage to the emitter,
   wherein a magnitude of the first voltage is determined based on quantum capacitance of the emitter determined by a voltage between the source electrode and the drain electrode.

10. The transistor device according to claim 9, wherein a second voltage is applied between the source electrode and the drain electrode,

wherein a magnitude of the first voltage is greater than or equal to -10 V and less than 0 V, or greater than 0 V and less than or equal to 10 V, and

a magnitude of the second voltage is greater than 0 V and less than or equal to 200 V.

11. A field-effect transistor comprising:

the transistor device according to any one of claims 1 to 10 and configured to operate in a vacuum state; and a conductive lead electrically connected to the source electrode, the gate structure, and the drain electrode of the transistor device.

12. A method for operating a transistor device, the method comprising:

preparing a source electrode located on a substrate comprising a dielectric material, and an emitter located on the substrate, electrically connected to the source electrode, and formed of a metalloid material with a two-dimensional (2D) structure;

modulating a work function of the emitter by applying a gate voltage to the emitter via a gate structure located on the emitter; and

emitting electrons from a tip of the emitter, to which the gate voltage and a drain voltage are applied, toward a drain electrode electrically separated from the source electrode and spaced apart from the emitter.

13. The method for operating the transistor device according to claim 12, wherein the emitting of the electrons comprises emitting electrons from the emitter into a vacuum region between the tip of the emitter and the drain electrode.

14. The method for operating the transistor device according to claim 12, wherein the modulating of the work function of the emitter comprises:

applying a first voltage to the tip of the emitter via a gate electrode; and

determining a magnitude of the first voltage based on quantum capacitance of the emitter determined by a voltage between the source electrode and the drain electrode.

15. The method for operating the transistor device according to claim 12, further comprising applying a second voltage between the source electrode and the drain electrode,

wherein the first voltage is greater than or equal to -10 V and less than 0 V, or greater than 0 V and less than or equal to 10 V, and

the second voltage is greater than 0 V and less than or equal to 200 V.

16. A method for manufacturing a transistor device, the method comprising:

forming an emitter having a two-dimensional (2D) structure formed of a metalloid material on a substrate comprising a dielectric material;

forming a gate insulating film on the metalloid material layer;

forming a gate electrode on the gate insulating film;

partially removing the dielectric material; and

forming a source electrode electrically connected to a portion of the emitter and a drain electrode spaced apart from the emitter,

wherein the gate electrode is located between the source electrode and the drain electrode,

wherein the partially removing of the dielectric material comprises forming an undercut below the metalloid material layer.

17. The method for manufacturing the transistor device according to claim 16, wherein the forming of the gate insulating film comprises forming an insulating layer having a thickness less than or equal to a distance between the gate electrode and the emitter so that a voltage applied by the gate electrode modulates a work function of the emitter.

18. The method for manufacturing the transistor device according to claim 16, wherein the forming of the emitter comprises:

forming a metalloid material layer with a 2D structure having an edge with a radius of curvature less than or equal to a preset value on another substrate; and

transferring the metalloid material layer to the substrate.

19. A transistor device comprising:

a first transistor element; and
a second transistor element facing the first transistor element,
wherein each of the first transistor element and the second transistor element comprises:

an emitter located on a substrate comprising a dielectric material, the emitter being formed of a metalloid material with a two-dimensional (2D) structure and configured to selectively emit electrons;
a source electrode electrically contacting a portion of the emitter;
a drain electrode located on the substrate, spaced apart from the emitter, and electrically separated from the source electrode; and
a gate structure located on the emitter, and configured to apply a gate voltage for controlling electron emission by the emitter to the emitter by modulating a work function of the emitter,
wherein the first transistor element and the second transistor element are arranged so that directions of electron emission from the emitter toward the drain electrode are opposite to each other.

20. The transistor device according to claim 19, wherein the drain electrode of the first transistor element and the drain electrode of the second transistor element are integrally formed with each other.

21. The transistor device according to claim 19, wherein the drain electrode of each of the first transistor element and the second transistor element is formed on the substrate at a height lower than a top surface of the emitter.

【Fig. 1】

【Fig. 2】

【Fig. 3】

```
        ┌─────────────┐
        │    Start    │
        └──────┬──────┘
               │
               ▼
  ┌──────────────────────────────┐
  │ Prepare emitter electrically │
  │ connected to source electrode│ ─── S11
  │ and formed of metalloid      │
  │ material with 2D structure   │
  └──────────────┬───────────────┘
                 │
                 ▼
  ┌──────────────────────────────┐
  │ Apply voltage to emitter via │
  │ gate electrode to change work│ ─── S12
  │ function of emitter tip      │
  └──────────────┬───────────────┘
                 │
                 ▼
  ┌──────────────────────────────┐
  │ Emit current through vacuum  │
  │ channel between emitter tip  │ ─── S13
  │ and drain electrode          │
  └──────────────┬───────────────┘
                 │
                 ▼
        ┌─────────────┐
        │     End     │
        └─────────────┘
```

【Fig. 4】

【Fig. 5】

【Fig. 6】

【Fig. 7A】

【Fig. 7B】

【Fig. 8A】

【Fig. 8B】

【Fig. 9】

【Fig. 10A】

【Fig. 10B】

【Fig. 11】

【Fig. 12】

【Fig. 13】

【Fig. 14A】

【Fig. 14B】

【Fig. 15A】

【Fig. 15B】

【Fig. 15C】

【Fig. 16】

【Fig. 17】

```
                        ┌─────────┐
                        │  Start  │
                        └─────────┘
                             │
                             ▼
    ┌──────────────────────────────────────────────┐
    │  Form metalloid material layer with 2d structure │⌐── S21
    │     on substrate formed of dielectric material   │
    └──────────────────────────────────────────────┘
                             │
                             ▼
    ┌──────────────────────────────────────────────┐
    │  Form insulating layer on metalloid material layer │⌐── S22
    └──────────────────────────────────────────────┘
                             │
                             ▼
    ┌──────────────────────────────────────────────┐
    │  Pattern metalloid material layer and insulating layer │⌐── S23
    └──────────────────────────────────────────────┘
                             │
                             ▼
    ┌──────────────────────────────────────────────┐
    │  Form gate electrode by forming and patterning   │⌐── S24
    │      electrode material layer on insulating layer │
    └──────────────────────────────────────────────┘
                             │
                             ▼
    ┌──────────────────────────────────────────────┐
    │  Form vacuum channel by removing dielectric material │⌐── S25
    └──────────────────────────────────────────────┘
                             │
                             ▼
    ┌──────────────────────────────────────────────┐
    │  Form source and drain electrode by forming      │⌐── S26
    │     and patterning electrode material layer       │
    └──────────────────────────────────────────────┘
                             │
                             ▼
                        ┌─────────┐
                        │   End   │
                        └─────────┘
```

【Fig. 18A】

【Fig. 18B】

【Fig. 19】

【Fig. 20A】

【Fig. 20B】

## INTERNATIONAL SEARCH REPORT

| International application No. |
|---|
| **PCT/KR2024/001427** |

| A. | CLASSIFICATION OF SUBJECT MATTER |
|---|---|

**H01J 1/304**(2006.01)i; **H01J 1/46**(2006.01)i; **H01J 9/02**(2006.01)i

According to International Patent Classification (IPC) or to both national classification and IPC

| B. | FIELDS SEARCHED |
|---|---|

Minimum documentation searched (classification system followed by classification symbols)

H01J 1/304(2006.01); C01B 31/02(2006.01); H01J 1/30(2006.01); H01J 29/96(2006.01); H01J 31/12(2006.01); H01J 35/06(2006.01); H01J 7/18(2006.01); H01L 29/70(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 소스(source), 드레인(drain), 에미터(emitter), 트랜지스터(transistor), 진공 채널 (vacuum channel)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2023-0071348 A (CAT BEAM TECH) 23 May 2023 (2023-05-23)<br>See paragraphs [0028]-[0046]; and figures 1-6. | 1-4,8,11-13,16,19 |
| A | | 5-7,9-10,14-15,17-18,20-21 |
| Y | KR 10-2003-0064644 A (HEWLETT-PACKARD COMPANY) 02 August 2003 (2003-08-02)<br>See paragraphs [0025]-[0027]; and figure 6. | 1-4,8,11-13,16,19 |
| Y | KR 10-2002-0042960 A (ELECTRONICS AND TELECOMMUNICATIONS RESEARCH INSTITUTE) 08 June 2002 (2002-06-08)<br>See paragraphs [0034]-[0042]; and figures 6a-6i. | 8,16 |
| Y | KR 10-2000-0077094 A (NEC CORPORATION) 26 December 2000 (2000-12-26)<br>See paragraph [0036]. | 11 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 May 2024** | **01 May 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2024/001427** |

**C.     DOCUMENTS CONSIDERED TO BE RELEVANT**

| Category* | Citation of document, with indication, where appropriate, of the relevant passages | Relevant to claim No. |
| --- | --- | --- |
| Y | JP 2001-501769 A (MICRON TECHNOLOGY INC.) 06 February 2001 (2001-02-06)<br>     See pages 8-9; and figures 2-3. | 19 |
| X | YOON, Chul-Hyun et al. Numerical Simulation and Modeling for Vacuum Channel Field Effect Transistor Using semi-metallic two-dimensional Emitter. Samsung Global Technology Symposium. 21 April 2023. [Retrieved on 11 April 2024]. Retrieved from <URL:https://samsung-gts.technology/ict/?id=poster>.<br>     See entire document.<br>     "This document is a document declaring exceptions to lack of novelty by the applicant in an earlier application that serves as a basis for claiming priority of the present international application.' | 1-2,7,12-13 |

Form PCT/ISA/210 (second sheet) (July 2022)

**INTERNATIONAL SEARCH REPORT**
Information on patent family members

International application No.

**PCT/KR2024/001427**

| Patent document cited in search report | | | Publication date (day/month/year) | Patent family member(s) | | | Publication date (day/month/year) |
|---|---|---|---|---|---|---|---|
| KR | 10-2023-0071348 | A | 23 May 2023 | None | | | |
| KR | 10-2003-0064644 | A | 02 August 2003 | CA | 2390677 | A1 | 28 July 2003 |
| | | | | EP | 1333488 | A2 | 06 August 2003 |
| | | | | JP | 2003-308776 | A | 31 October 2003 |
| | | | | US | 2003-0141802 | A1 | 31 July 2003 |
| KR | 10-2002-0042960 | A | 08 June 2002 | None | | | |
| KR | 10-2000-0077094 | A | 26 December 2000 | DE | 10019250 | A1 | 15 March 2001 |
| | | | | JP | 2000-311976 | A | 07 November 2000 |
| | | | | JP | 3307361 | B2 | 24 July 2002 |
| JP | 2001-501769 | A | 06 February 2001 | AU | 2937297 | A | 26 November 1997 |
| | | | | DE | 69720203 | T2 | 12 February 2004 |
| | | | | EP | 0896730 | A1 | 17 February 1999 |
| | | | | EP | 0896730 | B1 | 26 March 2003 |
| | | | | KR | 10-0424967 | B1 | 23 July 2004 |
| | | | | KR | 10-2000-0010738 | A | 25 February 2000 |
| | | | | WO | 97-42644 | A1 | 13 November 1997 |

Form PCT/ISA/210 (patent family annex) (July 2022)

**EP 4 697 372 A1**

**REFERENCES CITED IN THE DESCRIPTION**

**Patent documents cited in the description**

- KR 100973124